(19) Europäisches Patentamt
European Patent Office
Office européen des brevets

(11) **EP 2 723 559 B1**

(12) **EUROPEAN PATENT SPECIFICATION**

(45) Date of publication and mention
of the grant of the patent:
**05.02.2025  Bulletin 2025/06**

(21) Application number: **12803351.1**

(22) Date of filing: **20.06.2012**

(51) International Patent Classification (IPC):
*B32B 18/00* (2006.01)  *C04B 35/56* (2006.01)
*C04B 35/58* (2006.01)  *C30B 29/36* (2006.01)
*C30B 29/38* (2006.01)  *C30B 29/60* (2006.01)
*C30B 29/68* (2006.01)  *C30B 33/10* (2006.01)
*H01M 4/136* (2010.01)  *H01M 4/36* (2006.01)
*H01M 4/58* (2010.01)  *H01M 4/62* (2006.01)
*H01M 10/0525* (2010.01)  *B82Y 40/00* (2011.01)
*C22C 29/06* (2006.01)  *C22C 29/10* (2006.01)
*C22C 29/16* (2006.01)

(52) Cooperative Patent Classification (CPC):
**C30B 29/60; B32B 18/00; C04B 35/5607;
C04B 35/5611; C04B 35/58021; C30B 29/36;
C30B 29/38; C30B 29/68; C30B 33/10;
H01M 4/136; H01M 4/366; H01M 4/58;
H01M 4/622; H01M 10/0525; B82Y 40/00;**   (Cont.)

(86) International application number:
**PCT/US2012/043273**

(87) International publication number:
**WO 2012/177712 (27.12.2012 Gazette 2012/52)**

(54) **COMPOSITIONS COMPRISING FREE STANDING TWO DIMENSIONAL NANOCRYSTALS**

ZUSAMMENSETZUNGEN MIT FREISTEHENDEN ZWEIDIMENSIONALEN NANOKRISTALLEN

COMPOSITIONS COMPRENANT DES NANOCRISTAUX BIDIMENSIONNELS LIBRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.06.2011  US 201161499318 P
09.08.2011  US 201161521428 P
17.01.2012  US 201261587172 P**

(43) Date of publication of application:
**30.04.2014  Bulletin 2014/18**

(73) Proprietor: **Drexel University
Philadelphia, PA 19104 (US)**

(72) Inventors:
• **BARSOUM, Michel, W.
Moorestown, NJ 08057 (US)**
• **ABDELMALAK, Michael, Naguib
Philadelphia, PA 19104 (US)**
• **GOGOTSI, Yury
Warminster, PA 18974 (US)**

(74) Representative: **Carpmaels & Ransford LLP
One Southampton Row
London WC1B 5HA (GB)**

(56) References cited:
**EP-A- 0 948 067      EP-A1- 1 381 099
WO-A1-2007/093011    WO-A2-02/081372
WO-A2-2005/007566    JP-A- 2005 158 725
JP-A- 2007 214 137    JP-A- H0 878 018
JP-A- H10 112 316     US-A1- 2003 224 168
US-A1- 2007 065 725   US-A1- 2011 104 464**

• **M. W. BARSOUM ET AL: "Room-Temperature
Deintercalation and Self-Extrusion of Ga from
Cr2GaN", SCIENCE, vol. 284, no. 5416, 7 May
1999 (1999-05-07), pages 937 - 939,
XP055162888, ISSN: 0036-8075, DOI: 10.1126/
science.284.5416.937**

**(Cont. next page)**

- J. TRAVAGLINI ET AL: "The corrosion behavior of Ti3SiC2 in common acids and dilute NaOH", CORROSION SCIENCE, vol. 45, no. 6, 1 June 2003 (2003-06-01), pages 1313 - 1327, XP055163782, ISSN: 0010-938X, DOI: 10.1016/S0010-938X(02)00227-5
- BEIBEI CHEN ET AL: "Microstructure and phase transformation of Ti 3 AC 2 (A = Al, Si) in hydrofluoric acid solution", CRYSTAL RESEARCH AND TECHNOLOGY, vol. 49, no. 10, 27 October 2014 (2014-10-27), pages 813 - 819, XP055163552, ISSN: 0232-1300, DOI: 10.1002/crat.201400189
- MICHEL W. BARSOUM: "The MN+1AXN phases: A new class of solids", PROGRESS IN SOLID STATE CHEMISTRY, vol. 28, no. 1-4, 1 January 2000 (2000-01-01), pages 201 - 281, XP055163744, ISSN: 0079-6786, DOI: 10.1016/S0079-6786(00)00006-6
- M. W. BARSOUM: "The Topotactic Transformation of Ti[sub 3]SiC[sub 2] into a Partially Ordered Cubic Ti(C[sub 0.67]Si[sub 0.06]) Phase by the Diffusion of Si into Molten Cryolite", JOURNAL OF THE ELECTROCHEMICAL SOCIETY, vol. 146, no. 10, 1 January 1999 (1999-01-01), pages 3919 - 3929, XP055163265, ISSN: 0013-4651, DOI: 10.1149/1.1392573
- J. N. COLEMAN ET AL: "Two-Dimensional Nanosheets Produced by Liquid Exfoliation of Layered Materials", SCIENCE, vol. 331, no. 6017, 3 February 2011 (2011-02-03), pages 568 - 571, XP055141317, ISSN: 0036-8075, DOI: 10.1126/science.1194975
- TZENOV N V ET AL: "SYNTHESIS AND CHARACTERIZATION OF TI3ALC2", JOURNAL OF THE AMERICAN CERAMIC SOCIETY, BLACKWELL PUBLISHING, MALDEN, MA, US, vol. 83, no. 4, 1 January 2000 (2000-01-01), pages 825 - 832, XP002310245, ISSN: 0002-7820
- HU C ET AL: "Low temperature thermal expansion, high temperature electrical conductivity, and mechanical properties of Nb4AlC3 ceramic synthesized by spark plasma sintering", JOURNAL OF ALLOYS AND COMPOUNDS, ELSEVIER SEQUOIA, LAUSANNE, CH, vol. 487, no. 1-2, 13 November 2009 (2009-11-13), pages 675 - 681, XP026742330, ISSN: 0925-8388, [retrieved on 20090818], DOI: 10.1016/J.JALLCOM.2009.08.036
- BARSOUM: "The Mn+1AXn Phases: A New Class of Solids", PROG SOLID ST CHAM, vol. 28, 2000, pages 201 - 281, XP002960598
- NAGUIB, M. ET AL.: "Two-Dimensional Nanocrystals Produced by Exfoliation of Ti3AlC2", ADVANCED MATERIALS, vol. 23, no. 37, 4 October 2011 (2011-10-04), pages 4248 - 4253, XP055141316
- EKLUND ET AL.: "The Mn+1AXn phases: Materials science and thin-film processing Thin Solid Films", THIN SOLID FILMS, vol. 518, no. 8, 2010, pages 1851 - 1878, XP026877049, Retrieved from the Internet <URL:http://dx.doi.org/10.1016/j.tsf.2009.07.184>
- COLEMAN ET AL.: "Two-Dimensional Nanosheets Produced by Liquid Exfoliation of Layered Materials", SCIENCE, 4 February 2011 (2011-02-04), pages 568 - 571, XP055141317
- KULKARNI ET AL.: "Thermal expansion and stability of Ti2SC in air and inert atmospheres", JOURNAL OF ALLOYS AND COMPOUNDS, vol. 469, 2009, pages 395 - 400, XP025881620
- KORZHAVYI, P.A. ET AL.: "Ab initio study of phase equilibria in TiCx", PHYSICAL REVIEW LETTERS, vol. 88, no. 1, 2002, pages 015505-1 - 015505-3, XP055141320

(52) Cooperative Patent Classification (CPC): (Cont.)
C04B 2235/3239; C04B 2235/3241;
C04B 2235/604; C04B 2235/77; C04B 2237/36;
C22C 29/06; C22C 29/10; C22C 29/16; Y02E 60/10

**Description**

**GOVERNMENT INTERESTS**

This invention was made with government support under a grant from the U.S. Department of Energy under Contract No. DE-AC02-05CH11231, Subcontract 6951370.

**TECHNICAL FIELD**

The present invention is directed to compositions comprising free standing two dimensional crystalline solids, and methods of making the same.

**BACKGROUND**

Typically, two-dimensional, 2-D, free-standing crystals exhibit properties that differ from those of their three-dimensional, 3-D, counterparts. Currently, however, there are relatively few materials which can be described as 2-D, atomically-scaled layered solids. Clearly the most studied freestanding 2-D material is graphene, but other materials include hexagonal BN, certain transition metal oxides, hydroxides, and silicates, including clays, $S_2N$, $MoS_2$ and $WS_2$ are also known. Currently, the number of non-oxide materials that have been exfoliated is limited to two fairly small groups, viz. hexagonal, van der Waals bonded structures (e.g. graphene and BN) and layered metal chalcogenides (e.g. $MoS_2$, $WS_2$, etc.).

Although graphene has attracted more attention than all other 2-D materials together, its simple chemistry and the weak van der Waals bonding between layers in multi-layer structures limit its use. Given the properties of graphene for applications ranging from composite reinforcement to electronics, there is interest in other new materials which may also be described as 2-D, atomically-scaled layered solids.

WO2007/093011A1 describes a method of forming $M_{n+1}AX_n$, wherein M is an early transition metal (such as Ti), A is a group III or IV element (such as Si) or mixtures thereof and X is C, N or mixture thereof.

Barsoum and Farber, Science, 284 (1999), pp 937-939 describe the self-extrusion of Ga filaments from bulk $Cr_2GaN$.

Travaglini et al., Corrosion Science, 45 (2003), 1313-1327, describes the corrosion behavior of $Ti_3SiC_2$.

Barsoum et al., Journal of The Electrochemical Society, 146 (1999), 3919-3923, describes the topotactic transformation of $Ti_3SiC_2$ into partially ordered cubic $Ti(C_{0.67}Si_{0.06})$.

Barsoum et al., Progress in Solid State Chemistry, 28 (2000), 201-281 relates to Mn+1AXn phases as a class of solids.

**SUMMARY**

This invention is directed to compositions comprising free standing and stacked assemblies of two dimensional crystalline solids, and methods of making the same.

The invention provides a composition as defined in claim 1.

Still further embodiments provide polymer composites comprising an organic polymer and at least one composition described in the preceding paragraphs.

The invention also provides at least one stacked assembly as defined in claim 11.

In some embodiments, the stacked assemblies described in the preceding paragraphs are capable of, or have atoms or ions, that are intercalated between at least some of the layers. In other embodiments, these atoms or ions are lithium. In still other embodiments, these structures are part of an energy storing device or a battery.

This invention also provides methods of preparing compositions as defined in claim 20.

**BRIEF DESCRIPTION OF THE DRAWINGS**

The following figures are presented as illustrative examples, and should not be considered to limit the scope of the invention in any way. Except where otherwise noted, the scales of the figures may be exaggerated for illustrative purposes.

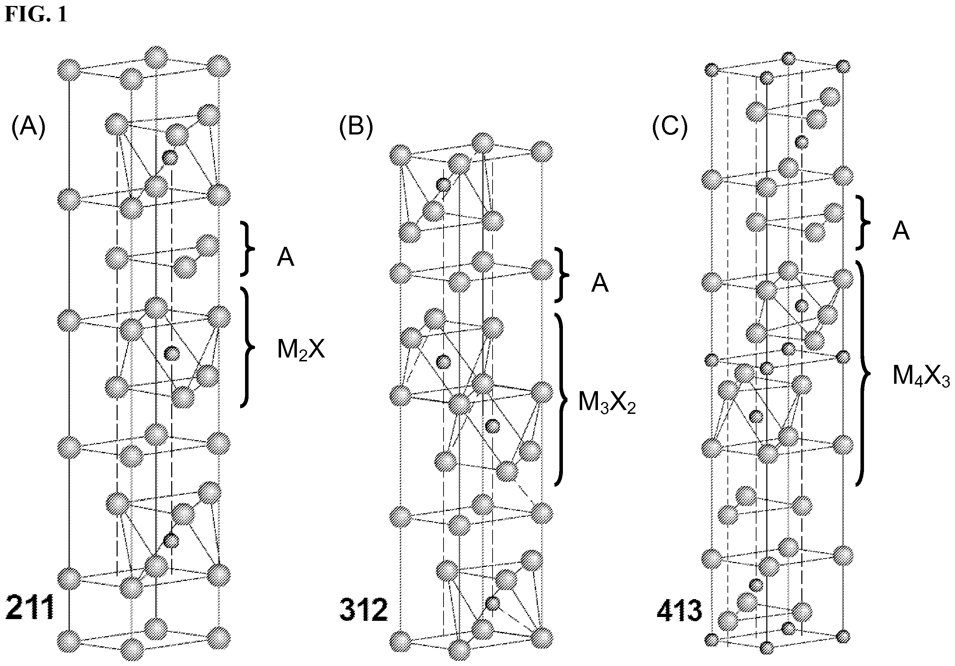

**FIG. 1** illustrates indicative crystal structures of the MAX phases in which the transitional metal carbide or nitride ($M_{n+1}X_n$) layers are interleaved with layers of pure A-group element. **FIG. 1A** illustrates the configuration of the $M_2X$ framework within the 211 class of MAX phase compounds, wherein every third layer is A-group. **FIG. 1B** illustrates the configuration of the $M_3X_2$ framework within the 312 class of MAX phase compounds, wherein every fourth layer is A-group. **FIG. 1C** illustrates the configuration of the $M_4X_3$ framework within the 413 class of MAX phase compounds, wherein every fifth layer is A-group.

**FIG. 2** provides a 3-dimensional (**FIG. 2A**) and 2-dimensional (**FIG. 2B**) representation of the crystal structure of the 312 class of compounds

**FIG. 3** illustrates a schematic representation of the exfoliation process for $Ti_3AlC_2$. **FIG. 3(a)** provides the $Ti_3AlC_2$ structure. **FIG. 3(b)** diagrammatically illustrates a structure where the Al atoms have been replaced by OH after reaction with HF. **FIG. 3(c)** illustrates a structure resulting from the subsequent breakage of the hydrogen bonds and separation of nano-sheets after sonication in methanol.

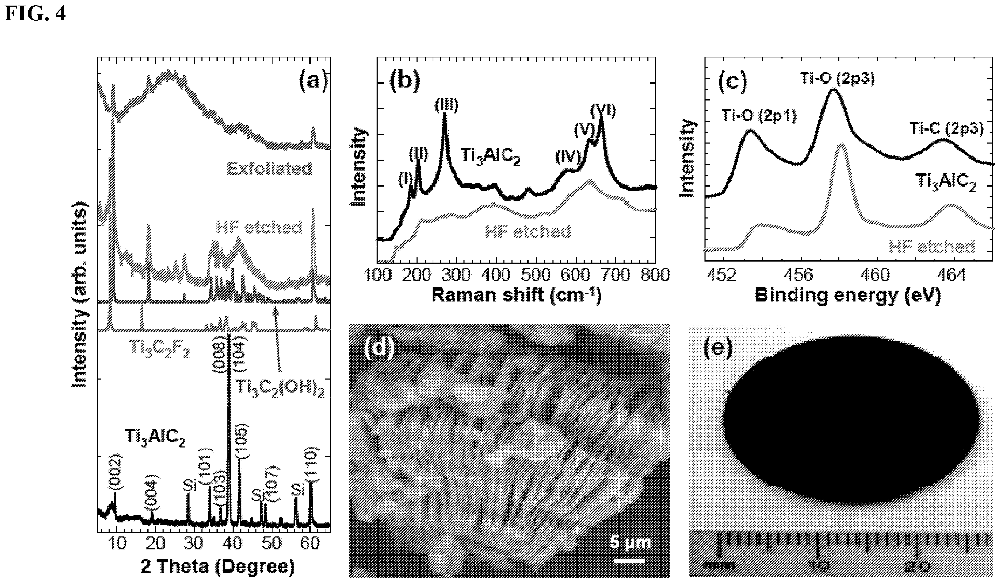

**FIG. 4** provides analytical date of the $Ti_3AlC_2$ before and after exfoliation. **FIG. 4(a)** provides an XRD pattern for $Ti_3AlC_2$ before any treatment, simulated XRD patterns of $Ti_3C_2F_2$ and $Ti_3C_2(OH)_2$, measured XRD patterns of $Ti_3AlC_2$ after HF treatment, and exfoliated nanosheets produced by sonication. **FIG. 4(b)** shows Raman spectra of $Ti_3AlC_2$ before and after HF treatment. **FIG. 4(c)** provides XPS spectra of $Ti_3AlC_2$ before and after HF treatment. **FIG. 4(d)** provides an SEM image of a sample after HF treatment. **FIG. 42(e)** shows a cold processed 25 mm disk of etched and exfoliated material after HF treatment.

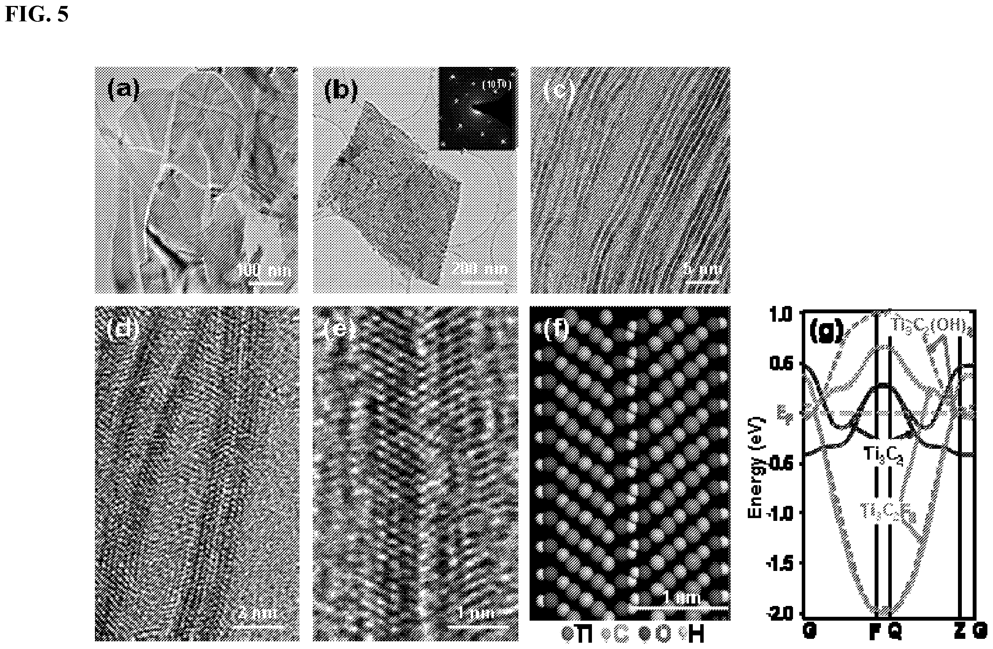

**FIG. 5** shows micrographs of exfoliated MXene nanosheets. **FIG. 5(a)** shows TEM micrographs of exfoliated 2-D nanosheets of Ti-C-O-F. **FIG. 5(b)** shows TEM micrographs of exfoliated 2-D nanosheets; inset selected area diffraction, SAD, shows hexagonal basal plane. **FIG. 5(c)** shows TEM micrographs of single and double layer MXene sheets. **FIG. 5(d)** shows an HRTEM image showing the separation of individual sheets after sonication. **FIG. 5(e)** shows an HRTEM image of bilayer $Ti_3C_2(OH)_xF_y$. **FIG. 5(f)** shows an atomistic model of the layer structure shown in **FIG. 5(e)**. **FIG. 5(g)** shows a calculated band structure of single layer MXene with -OH and -F surface termination and no termination ($Ti_3C_2$), showing a change from metal to semiconductor as a result of change in the surface chemistry.

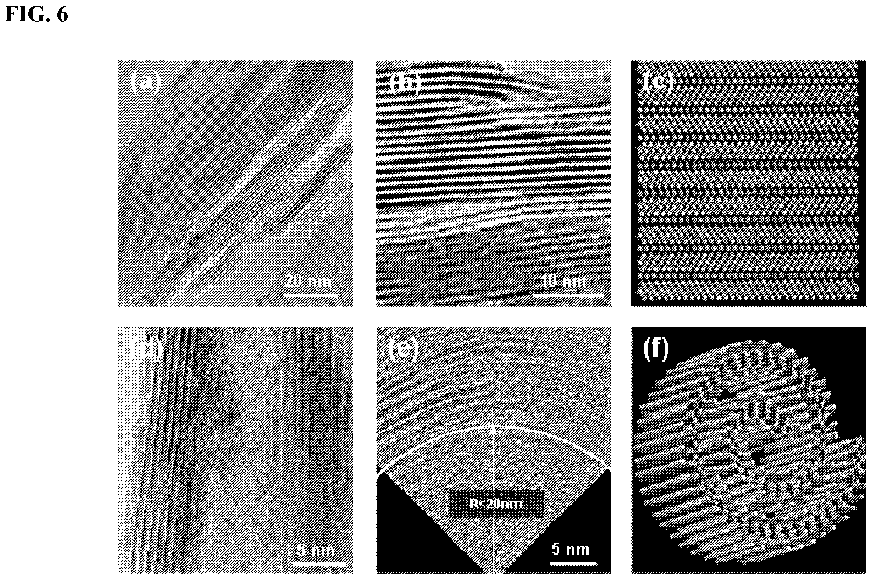

**FIG. 6** provides TEM images and simulated structures of multi-layer MXene. **FIG. 6(a)** provides TEM micrographs for stacked layers of Ti-C-O-F. Those are similar to multilayer graphene or exfoliated graphite that finds use in electrochemical storage. **FIG. 6(b)** provides TEM micrographs for the same stacked layers **FIG. 6(a)** but at a higher magnification. **FIG. 6(c)** provides a model of the Li-intercalated structure of $Ti_3C_2$ ($Ti_3C_2Li_2$). **FIG. 6(d)** provides TEM micrographs for a conical scroll of about 20 nm in outer diameter. **FIG. 6(e)** provides a cross sectional TEM image of a scroll with inner radius less than 20 nm. **FIG. 6(f)** provides a schematic representation of an MXene scroll (OH-terminated).

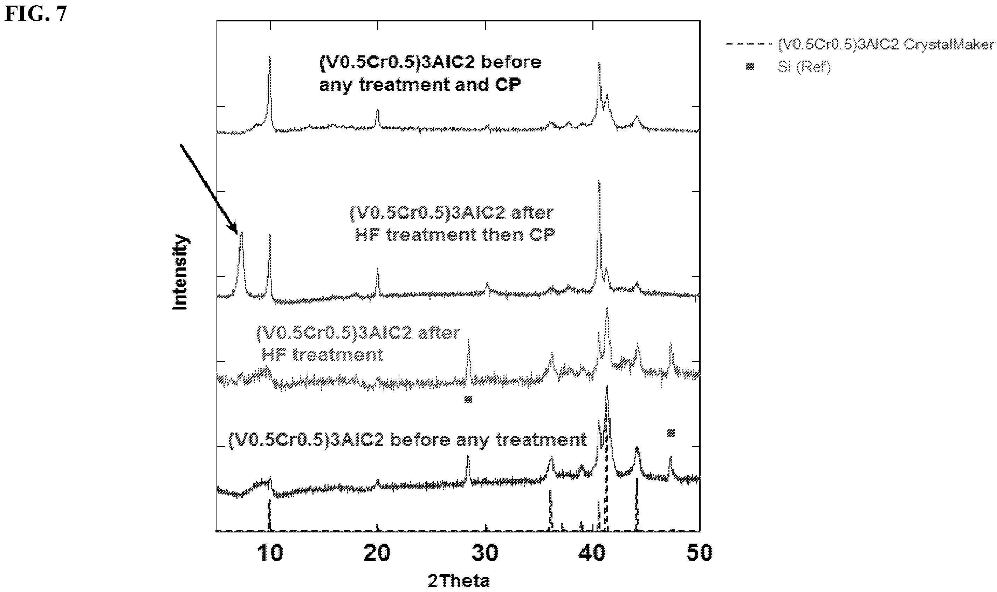

**FIG. 7** provides X-ray diffraction patterns of $(V_{1/2}Cr_{1/2})_3AlC_2$ before and after exfoliation. From the bottom up, **FIG. 7** provides a simulated XRD pattern for $(V_{1/2}Cr_{1/2})_3AlC_2$ as determined by CrystalMaker software, and measured XRD patterns for powdered $(V_{1/2}Cr_{1/2})_3AlC_2$ before any treatment, $(V_{1/2}Cr_{1/2})_3AlC_2$ after HF treatment, $(V_{1/2}Cr_{1/2})_3AlC_2$ after HF treatment and cold pressing (CP), and $(V_{1/2}Cr_{1/2})_3AlC_2$ before any treatment or cold pressing. The peak at $2\theta = 7.3°$ appears only after HF treatment and cold pressing. By analogy to the results shown for $Ti_3AlC_2$, this peak is attributed to $(V_{1/2}Cr_{1/2})_3C_2$. See Example 5.

**FIG. 8** shows SEM micrographs and XRD spectra of chemically exfoliated $Ti_2AlC$.

**FIG. 9** shows a secondary electron SEM micrograph for TiNbAlC after HF treatment and XRD patterns before and after HF treatment at room temperature for TiNbAlC (50% HF 28 hrs) (inset is the XRD for $(V_{0.5}Cr_{0.5})AlC_2$; 50% HF 65 hrs, and cold pressed zoomed-in on the (0002) peak).

**FIG. 10** shows SEM micrographs and XRD spectra of chemically exfoliated $Ti_4AlC_3$ (50% HF 72 hours at RT).

**FIG. 11** shows SEM micrographs and XRD spectra of chemically exfoliated $Ti_3AlCN$ (30% HF 18 hours at RT).

**FIG. 12** shows additional SEM micrographs of chemically exfoliated $Ti_3AlCN$ (30% HF 18 hours at RT).

**FIG. 13** shows additional SEM micrographs of chemically exfoliated $Ti_3AlCN$ (30% HF 18 hours at RT).

**FIG. 14** shows SEM micrographs and XRD spectra of chemically exfoliated $(V_{1/2}Cr_{1/2})_3AlC_2$ (50% HF 69 hours at RT).

**FIG. 15** shows additional SEM micrographs of chemically exfoliated $(V_{1/2}Cr_{1/2})_3AlC_2$ (50% HF 69 hours at RT).

**FIG. 16** shows SEM micrographs of chemically exfoliated $(V_{1/2}Cr_{1/2})_3AlC_2$ (50% HF 69 hours at RT).

**FIG. 17** shows SEM micrographs and EDX analytical results of chemically exfoliated $Ti_3AlC_2$ (10% HF 2 hours at 65°C).

**FIG. 18(a/b)** shows TEM micrographs of chemically exfoliated $Ti_3AlC_2$ (50% HF 22 hours at RT). **FIG. 18(b)** is an enlargement of bottom micrograph of **FIG. 18(a).**

**FIG. 19** shows XRD spectra for samples of chemically exfoliated $Ti_3AlC_2$, generated as a function of temperature in 50 wt% HF for 2 hours.

**FIG. 20** shows XRD spectra for samples of chemically exfoliated $Ti_3AlC_2$, generated as a function of time in 50 wt% HF at room temperature.

**FIG. 21** shows resistivity for various chemically exfoliated $Ti_3AlC_2$, generated as a function of time, in 50% HF at ambient temperature.

**FIG. 22** shows XRD spectra for samples of chemically exfoliated $Ti_3AlC_2$, generated as a function of initial particle size of the MAX phase precursor. The materials were held for 2 hours in 50 wt% HF at room temperature

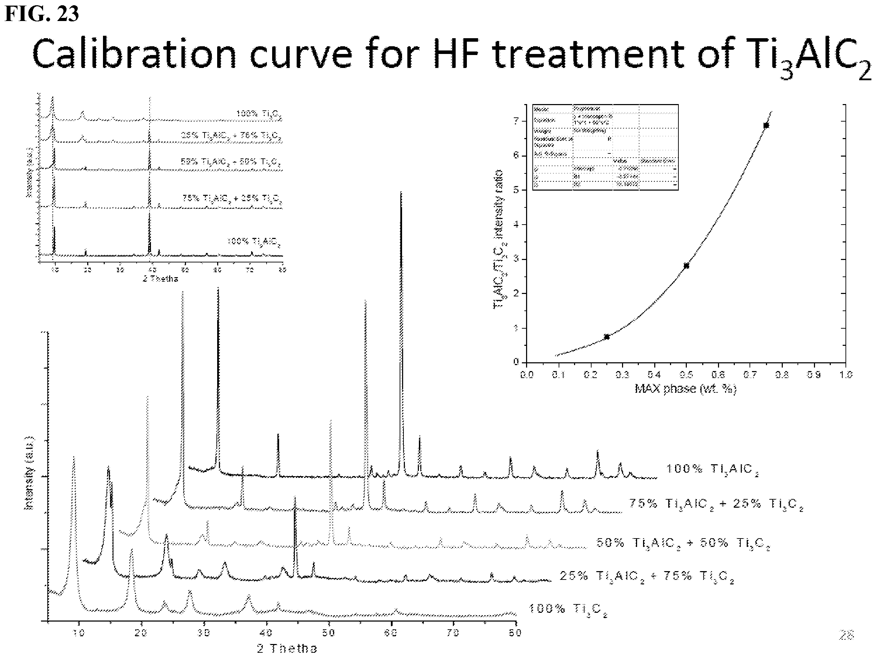

**FIG. 23** shows XRD spectra forming the basis for a calibration curve of chemically exfoliated $Ti_3AlC_2$, generated as a function of composition.

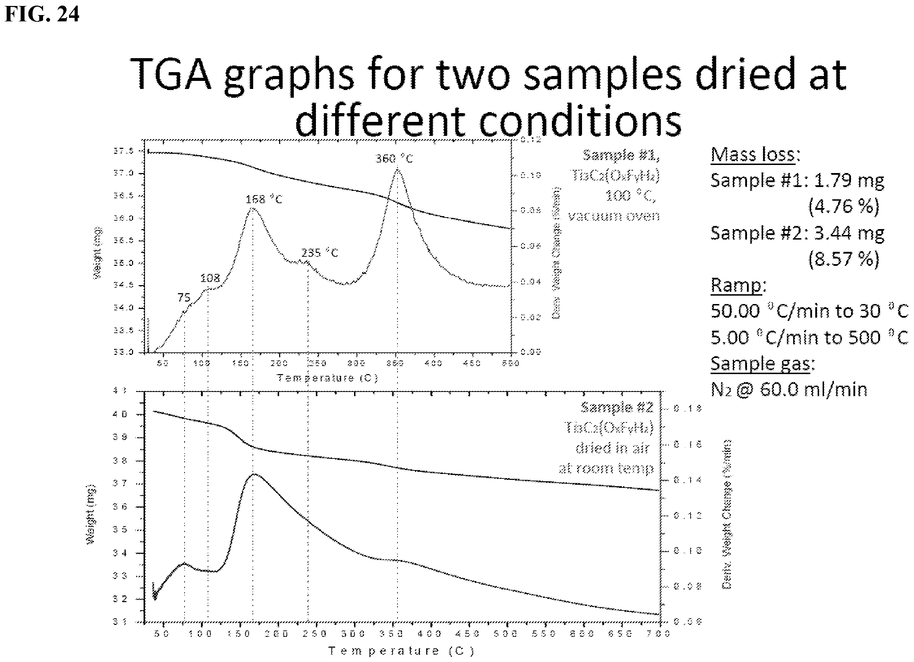

**FIG. 24** shows TGA graphs for two samples of $Ti_3C_2(OH)_x(F)_y$ prepared at two different drying conditions

**FIG. 25** shows exemplary experimental parameters for tests to evaluate the electrochemical exfoliation of MAX phase materials; see Example 9.

**FIG. 26** shows a series of Raman spectra for samples obtained in tests described in Example 8. Curves (a) and (b) are the spectra of the exfoliated material obtained after the electrochemical aniodic polarization treatment of the $Ti_2SnC$ MAX phase in 12 M HCl. Curves (c) through (e) are the initial spectra of $Ti_2SnC$.

**FIG. 27(a)** shows the XRD data of the exfoliated material obtained after the electrochemical aniodic polarization treatment of the $Ti_2SnC$ MAX phase in 12 M HCl. **FIG. 27(b)** shows the XRD data of the initial $Ti_2SnC$ material. **FIG. 27(c)** shows the XRD data of the $Ti_2SnC$ material treated in Ar as 1250°C. **FIG. 27(d)** is a simulated XRD pattern for the $Ti_2SnC$ system. Note: the asterisks and crossed boxes mark the characteristic peak positions of $Si_{pc}$ and TiC, respectively.

**FIG. 28(a, b, c)** show SEM and EDX/EDS data of the exfoliated material obtained after the electrochemical aniodic polarization treatment of the $Ti_2SnC$ MAX phase in 12 M HCl. The circles represent the approximate area subjected to EDX/EDS analysis.

**FIG. 29(a)** shows the results of electrochemical testing described in Example 10. The labels "Exfoliated" and "Not Exfoliated" refer to the samples used in the testing corresponding to exfoliated and not exfoliated particles of $Ti_3AlC_2$.

**FIG. 30(a)** shows an SEM image of exfoliated $Ti_2CO_x$ produced by HF treatment of $Ti_2AlC$, and FIG 30(B) shows $N_2$ adsorption-desorption isotherms of the material shown in **FIG. 30(a),** red circles refer to adsorption and green squares refer to desorption. The calculated SSA is approximately 23 $m^2.g^{-1}$.

**FIG. 31(a)** shows cyclic voltammetry curves of exfoliated $Ti_2C$ at a constant scan rate of 0.2 mV·$s^{-1}$. The solid arrows refer to main peaks positions during lithiation and delithiation cycles. **FIG. 31(b)** provides the galvanostatic charge/discharge curves at a C/10 rate. **FIG. 31(c)** shows specific lithiation (circles in the figure) and delithiation (squares in the figure) capacities (per mass of active material) vs. cycle number at different rates. The inset in **FIG. 31(c)** is a zoom of the first 20 cycles

## DETAILED DESCRIPTION OF ILLUSTRATIVE EMBODIMENTS

The present invention may be understood more readily by reference to the following detailed description taken in connection with the accompanying Figures and Examples, which form a part of this disclosure. It is to be understood that this invention is not limited to the specific products, methods, conditions or parameters described and / or shown herein, and that the terminology used herein is for the purpose of describing particular embodiments by way of example only and is not intended to be limiting of any claimed invention. Similarly, unless specifically otherwise stated, any description as to a possible mechanism or mode of action or reason for improvement is meant to be illustrative only, and the invention herein is not to be constrained by the correctness or incorrectness of any such suggested mechanism or mode of action or reason for improvement. Throughout this text, it is recognized that the descriptions refer both to compositions and to the articles and devices derived therefrom, as well as the methods of manufacture and use.

In the present disclosure the singular forms "a," "an," and "the" include the plural reference, and reference to a particular numerical value includes at least that particular value, unless the context clearly indicates otherwise. Thus, for example, a reference to "a material" is a reference to at least one of such materials and equivalents thereof known to those skilled in the art, and so forth.

When values are expressed as approximations by use of the antecedent "about," it will be understood that the particular value forms another embodiment. In general, use of the term "about" indicates approximations that can vary depending on the desired properties sought to be obtained by the disclosed subject matter and is to be interpreted in the specific context in which it is used, based on its function, and the person skilled in the art will be able to interpret it as such. In some cases, the number of significant figures used for a particular value may be one non-limiting method of determining the extent of the word "about." In other cases, the gradations used in a series of values may be used to determine the intended range available to the term "about" for each value. Where present, all ranges are inclusive and combinable. That is, reference to values stated in ranges includes each and every value within that range.

Various embodiments of this invention provide for crystalline compositions comprising at least one layer having first and second surfaces, each layer comprising a two-dimensional array of crystal cells; each crystal cell is an ordered array of atoms having an empirical formula of $M_{n+1}X_n$ , such that each X is positioned within an octahedral array of M; wherein M is at least one Group IIIB, IVB, VB, or VIB metal; wherein each X is C or N (i.e., stoichiometrically X = $C_xN_y$, including where x + y = 1); and n = 1, 2, or 3. In some embodiments, these compositions comprise a plurality of layers. Other embodiments provide for stacked assemblies of such layers. Collectively, such compositions are referred to herein as "MXene," "MXene compositions," or "MXene materials." Additionally, these terms "MXene," "MXene compositions," or "MXene materials" also refer to those compositions derived by the chemical exfoliation of MAX phase materials, whether these compositions are present as free-standing 2-dimensional or stacked assemblies (as described further below). **FIG. 1** provides a representation of the crystal cells of various $M_{n+1}X_n$ (where n = 1, 2, or 3) frameworks, presented however, in the context of corresponding MAX-phase materials (see also below). In various embodiments, each X is positioned within an octahedral array of M.

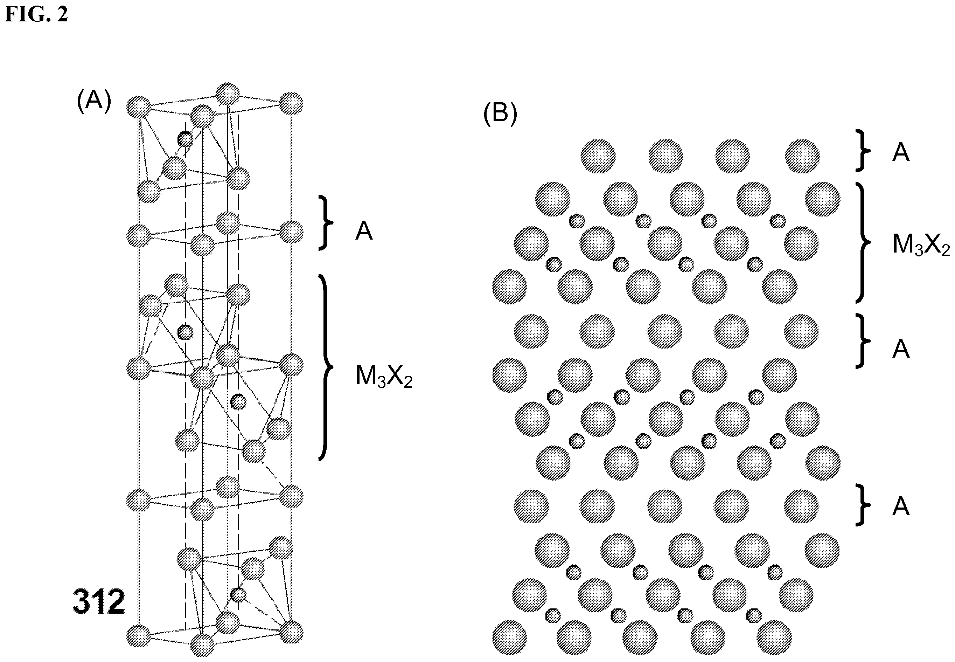

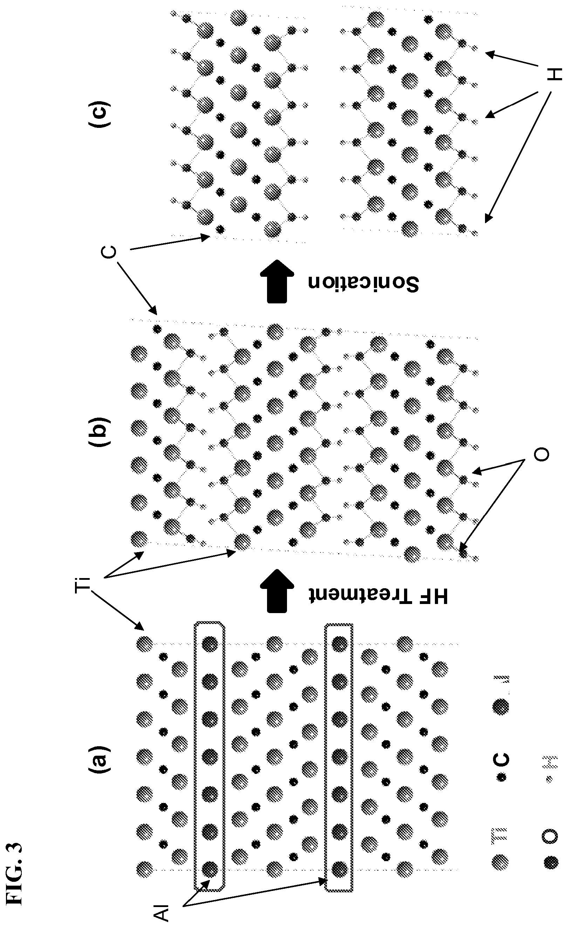

Analogous to other so-called two-dimensional, atomically-scaled layered solid materials, such as graphene or hexagonal BN, these MXene crystalline compositions are free-standing or be present in stacked compositions. As used herein, the term "free standing" refers to individual layers wherein the adjacent composite crystal layers are not bonded to one another by covalent bonds or connected by metal-lattice bonds, but may be joined by intervening hydrogen (or even weaker) bonding, such that each such layer can be physically manipulated. See e.g., **FIGs. 2** and **3.** However, this term does not preclude the deposition of these layers or stacked layers on substrates or within polymer compositions (see also below).

The term "crystalline compositions comprising at least one layer having first and second surfaces, each layer comprising a substantially two-dimensional array of crystal cells" refers to the unique character of these materials. For purposes of visualization, the two-dimensional array of crystal cells may be viewed as an array of cells extending in an x-y plane, with the z-axis defining the thickness of the composition, without any restrictions as to the absolute orientation of that plane or axes. According to the invention, the at least one layer having first and second surface contains but a single two-dimensional array of crystal cells, that is, the z-dimension is defined by the dimension of a single, i.e. one, crystal cell, such that the planar surfaces of said cell array defines the surface of the layer.

That is, as used herein, "a substantially two dimensional array of crystal cells" refers to an array which includes a lateral (in x-y dimension) array of crystals having a thickness of a single cell (e.g., corresponding to the $M_2X$, $M_3X_2$, or $M_4X_3$ cells as depicted in FIG. 1), such that the top and bottom surfaces of the array are available for chemical modification.

It should also be appreciated that, analogous to graphene or hexagonal BN compositions, this description of a planar or two-dimensional array should not be interpreted to describe a necessarily flat structure; rather such compositions may also take the form of a curved or undulating plane, a scroll, or a cylinder or tube (e.g., analogous to the structure of a carbon or BN nanotube).

According to the invention, the compositions contain C or N atoms, or a mixture thereof, but in any case, these atoms are positioned within an octahedral or pseudo-octahedral array of M atoms, reminiscent of the positioning of the carbon or nitrogen atom within MAX-phase materials. While not necessarily being bound to the scientific accuracy of this statement, this arrangement appears to protect the C and/or N atoms from external chemical attack, while at the same time providing a degree of structural strength to the 2-dimensional layers.

Given the difficulties in obtaining crystallographic evidence as to the crystallinity of materials having such few layers (e.g., less than about 5 cell layers), owing to the reduced level or lack of constructive interference of such few layers, these materials may be characterized by measuring the thickness of the individual layers (measured, for example, by Transmission Electron Micrography or atomic force microscopy). Depending on the particular empirical formula of the given material, the thickness of a given single cell layer will be on the order of about 0.2 to about 0.3 nm (preferably about 0.25 nm) for $M_2X$ compositions, about 0.3 to about 0.7 nm (preferably about 0.5 nm) for $M_3X_2$ compositions, and about 0.6 to about 0.9 nm (preferably about 0.75 nm) for $M_4X_3$ compositions. As described more fully below, one method of preparing these compositions is to react a precursor MAX phase material so as to remove the labile A-phase, and exfoliating the resulting structure. In these cases, it is so generally observed that the crystallinity of the resulting MXene framework, which existed in the original MAX phase structure, is sufficiently robust as to be retained during the preparation process, so that the thickness measurements by themselves can be used to characterize the materials, even in the absence of crystallographic analysis.

These MXene materials (even individual or exfoliated layers) can also be characterized by measuring the X-ray diffraction (XRD) spectra of (optionally cold pressed) stacked layers (see, e.g., Example 2, **FIG. 4(a)** and Example 4, **FIG. 7** below). That is, such stacking provides a sample of sufficient thickness (number of layers) to allow for sufficient constructive interference so as to provide for a measurable XRD pattern to be obtained. One distinguishing feature of XRD patterns thus generated is the presence of peaks at $2\theta$ of ca. 5-7° (i.e., between about 4.5° and about 9.5° when Cu $K_\alpha$ radiation is used), corresponding to the d-spacing (thickness) of the individual layers (including the surface coatings of each layer) and lower than the (002) peaks of the corresponding MAX phase materials. That this MXene peak occurs at lower $2\theta$ values, reflecting higher d-spacings of the layers, than the corresponding (002) plane in a corresponding MAX phase material is consistent with the greater spacing of the crystal cells of the two materials in the former relative to the latter (e.g., referring to **FIG. 3,** the individual layers of the $Ti_3C_2$ in **FIG. 3(b)** are spaced further apart than the corresponding layers in **FIG. 3(a)).**

According to the invention, the terms "M" or "M atoms," "M elements," or "M metals" refers to one or more members of the Groups IIIB, IVB, VB, or VIB or (aka) Groups 3-6 of the periodic table, either alone or in combination, said members preferably including Sc, Y, Lu, Ti, Zr, Hf, V, Nb, Ta, Cr, Mo, and W. In preferred embodiments, the transition metal is one or more of Sc, Ti, Zr, Hf, V, Nb, Ta, Cr, and/or Mo. In other preferred embodiments, the transition metal is one or more of Ti, Zr, V, Cr, Nb, and/or Ta. In even more preferred embodiments, the transition metal is Ti, Ta, V, and/or Cr.

The empirical formula $M_{n+1}X_n$, wherein X is C, N, or a combination thereof, and n = 1, 2, or 3 gives rise to a number of possible composition. For example, and while not intending to be limited to this list, exemplary compositions when n = 1 includes those wherein the empirical formula is $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, and $Hf_2N$. Similarly, non-limiting exemplary compositions when n = 2 includes those wherein the empirical formula is $Ti_3C_2$, $Ti_3N_2$, $V_3C_2$, $V_3C_2$, $Ta_3C_2$, and $Ta_3N_2$ and when n = 3 includes those wherein the empirical formula is $Ti_4C_3$, $Ti_4N_3$, $V_4C_3$, $V_4N_3$, $Ta_4C_3$ and $Ta_4N_3$. Especially important embodiments include those where M comprises at least one Group IVB element, for example Ti, Zr, or Hf and those where M comprises at least one Group V elements, for example V, Nb, or Ta. More preferred independent embodiments include those where M is Ti or Ta, especially structures wherein the empirical formula is $Ti_2C$, $Ti_2N$, $Ti_3C_2$, $Ti_3N_2$, $Ti_4C_3$, or $Ti_4N_3$, or $Ta_3C_2$, $Ta_3N_2$, $Ta_4C_3$ or $Ta_4N_3$, especially $Ti_2C$ or $Ta_4C_3$.

The range of compositions available can be seen as extending even further when one considers that each M-atom position within the overall $M_{n+1}X_n$ matrix can be represented by more than one element. That is, one or more type of M-atom can occupy each M-positions within the respective matrices. In certain exemplary non-limiting examples, these can be $(M^A{}_xM^B{}_y)_2C$ or $(M^A{}_xM^B{}_y)_2N$, $(M^A{}_xM^B{}_y)_3C_2$ or $(M^A{}_xM^B{}_y)_3C_2$, or $(M^A{}_xM^B{}_y)_4C_3$ or $(M^A{}_xM^B{}_y)_4C_3$, where $M^A$ and $M^B$ are independently members of the same group, and x + y = 1. For example, in but one non-limiting example, such a composition can be $(V_{1/2}Cr_{1/2})_3C_2$. In the same way, one or more type of X-atom can occupy each X-position within the matrices, for example solid solutions of the formulae $M_{n+1}(C_xN_y)_n$, or $(M^A{}_xM^B{}_y)_{n+1}(C_xN_y)_n$.

In various embodiments, the composition's layer has first and second surfaces which are capable of being physically or chemically interrogated or modified. This feature distinguishes these compositions from sputtered matrices or so-called MAX phase compositions. While it may be possible to describe sputtered matrices or MAX phase compositions as containing two-dimensional arrays of crystal cells, in each case these are embedded within vertically integrated and practically bound to other layers within the respective matrices (e.g., in the case of sputtered matrices, to other neighboring sputtered layers or the substrate; in the case of MAX-phase compositions, to interleaved A-group element arrays), either by covalent, metallic, or lattice bonds, and which cannot be separately accessed. By contrast, in various embodiments of the present compositions, each layer has two available or accessible surfaces sandwiching each substantially two-dimensional array of crystal cells, each of which surfaces can be accessed for physical or chemical interrogation or modification.

The ability to functionalize the surfaces of the layers of the present invention provides a considerable synthetic and structural flexibility. Because of the arrangement of the M atoms within the $M_{n+1}X_n$ framework, wherein each X is positioned within an octahedral array of M atoms, the "unfunctionalized" surface comprises largely M atoms. For example, in the absence of imperfections, a substantially planar array of crystal cells having an empirical formula $Ti_3C_2$ will provide or

present external surfaces comprising a planar array of Ti atoms (see, e.g., FIG. 3). At the same time, owing to the chemical reactivity of Ti (or any of the M atoms), these surfaces will be coated with one or more organic or inorganic moieties, generally comprising heteroatoms or having heteroatom linking groups.

For example, in certain embodiments, at least one of the surfaces are coated with a coating comprising H, N, O, or S atoms, for example, a hydride, oxide, sub-oxide, nitride, sub-nitride, sulfide, or optionally a sub-sulfide. In preferred embodiments, the coating comprises a hydrated or anhydrous oxide, a sub-oxide, or some combination thereof. As used herein the terms "sub-oxide," "sub-nitride," or "sub-sulfide" is intended to connote a composition containing an amount reflecting a sub-stoichiometric or a mixed oxidation state of the M metal at the surface of oxide, nitride, or sulfide, respectively. For example, various forms of titania are known to exist as $TiO_x$, where x can be less than 2. Accordingly, the surfaces of the present invention may also contain oxides, nitrides, or sulfides in similar sub-stoichiometric or mixed oxidation state amounts.

In other embodiments, at least one surface is coated with a coating having a pendant moiety which is linked to the surface by an N, O, or S atom (e.g., an M-N, M-O, or M-S bond, respectively). Such surface coatings then may comprise at least one hydroxide, alkoxide, carboxylate, amine, amide, or thiol. These pendants may contain organic moieties, including saturated, unsaturated, and/or aromatic moieties. These organic moieties may optionally include heteroatoms, be linear or branched, and/or may contain one or more functional groups, for example amines and derivatives therefrom, (thio)carboxylic acids and derivatives therefrom, hydroxy or ether groups, and/or thiol groups. The moieties and/or optionally available functional groups may exist in their neutral or ionized state.

In other embodiments, the coating of at least one surface comprises at least one halide, for example F, Cl, Br, or I, preferably F. As used herein, the terms "halide" and, e.g., "fluoride" are intended to reflect the presence of metal-halogen or metal-fluorine bonds, respectively, without regard to the specific nominal charge on the halogen or fluorine.

The skilled artisan will be able to interchange the pendant groups by methods known in the art. Without the need for an exhaustive delineation of such methods, in one non-limiting example, a hydroxy or alkoxy surface may be prepared by providing an excess hydroxide or alkoxide so as to displace the halide from an initially presented M-halide surface or so as to hydrate or alkoxylate a metal oxide or sub-oxide surface. Similarly, an originally presented M-hydroxide surface may be converted to oxide or sub-oxide surface by application of heat or other dehydrating conditions. Nitrogen and sulfur surfaces may be analogously interconverted by methods known in the art for making such conversions. Similarly, hydrides may be prepared by exposing precursors to reducing conditions, either electrolytically or by contacting with reducing agents such as hydrides (e.g., $NaBH_4$), hydrogen gas, or ammonia.

In certain embodiments, the compositions may be electrically conducting or semiconducting.

In certain embodiments, the compositions of the present invention comprises at least one individual layer having first and second surfaces, each layer comprising a substantially two-dimensional array of crystal cells having an empirical formula $Ti_3C_2$ , with at least one surface coated with a coating comprising a hydroxide, an oxide, a sub-oxide, or a combination thereof. In other embodiments, the coating comprises fluorine or fluoride.

In other embodiments, the crystalline composition comprises at least one individual layer having first and second surfaces, each layer comprising a substantially two-dimensional array of crystal cells having an empirical formula $Ta_4C_3$, with at least one surface coated with a coating comprising a hydroxide, an oxide, a sub-oxide, or a combination thereof.

In still other embodiments, the crystalline composition comprises at least one individual layer having first and second surfaces, each layer comprising a substantially two-dimensional array of crystal cells having an empirical formula $(Cr_xV_x)_3C_2$ (including where x = y = ½) with at least one surface coated with a coating comprising a hydroxide, an oxide, a sub-oxide, or a combination thereof.

As described above, certain additional embodiments provide MXene compositions which exhibit conductive or semi-conductive behavior, as well as those electronic devices (e.g., transistors, where the use of graphene and $MoS_2$ has been successfully demonstrated) which incorporate such compositions so as to take advantage of this property. Further, it is shown that variations in the nature of the surface coating effects that behavior, as shown by density functional theory (DFT) calculations (methods described in Example 1, below) (**FIG. 5(g)**). For example, the calculated band structure of a single $Ti_3C_2$ layer resembles a typical semi-metal with a finite density of states at the Fermi level. Indeed, the resistivity of the thin disk shown in **FIG. 4(e)** is estimated to about an order of magnitude higher than the same disc made with unreacted $Ti_2AlC$ powders, which translates to a resistivity of ≈ 0.03 μΩm. By contrast, when terminated with OH and F groups, the band structure has a semiconducting character with a clear separation between valence and conduction bands by 0.05 eV and 0.1 eV, respectively (**FIG. 5(g)**), thereby supporting the conclusion that it is possible to tune the electronic structure of exfoliated MAX layers - or MXene compositions - by varying the functional groups. Such further modifications of the functional groups themselves may provide additional flexibility in this regard.

Additional embodiments provide for the use or incorporation of MXene compositions into other materials, or the incorporation of other materials within them. For example, various embodiments provide polymer composites into which a MXene composition is incorporated. More particularly, further embodiments provide polymer composite compositions wherein the MXene compositions comprises between amounts in the range of about 0.1 wt% to about 50 wt%, relative to the combined weight of the polymer and MXene composition. Still other embodiments provide that the MXene composition is present in a range whose lower amount is about 0.1, about 1, about 2, about 5, or about 10 wt% and the upper amount is about 50 wt%, about 40 wt%, about 30 wt%, about 20 wt%, about 10 wt%, or about 5 wt%, relative to the combined weight of the polymer and the MXene composition comprising a polymer.

The polymer composite may be comprised of organic polymers, more specifically thermoset or thermoplastic polymers or polymer resins, elastomers, or mixtures thereof. Various embodiments include those wherein the polymer or polymer resin contains an aromatic or heteroaromatic moiety, for example, phenyl, biphenyl, pyridinyl, bipyridinyl, naphthyl, pyrimidinyl, including derivative amides or esters of terephthalic acid or naphthalic acid. Other embodiments provide that the polymer or polymer resin comprises polyester, polyamide, polyethylene, polypropylene, polyethylenenaphthalate (PEN), polyethylene terephthalate (PET), polybutylene terephthalate (PBT), polyether etherketone (PEEK), polyamide, polyaryletherketone (PAEK), polyethersulfone (PES), polyethylenenimine (PEI), poly (p-phenylene sulfide) (PPS), polyvinyl chloride (PVC), fluorinated or perfluorinated polymer (such as a polytetrafluoroethylene (PTFE or TEFLON®), polyvinylidene difluoride (PVDF), a polyvinyl fluoride (PVF or TEDLAR®)) (TEFLON® and TEDLAR® are registered trademarks of the E.I. DuPont de Nemours Company, of Wilmington, Delaware)

It is believed that the planar nature of MXene layers may be well suited to organizing themselves in those anisotropic polymers, for example having planar moieties, e.g., aromatic moieties, especially when (but not only when) these planar organic moieties are directionally oriented to be parallel in a polymer composite composition. Such embodiments include the inclusion of MXene compositions into liquid crystal polymers. Moreover, the ability to produce MXene compositions having both hydrophobic and hydrophilic pendants provides for compatibility with a wide-ranging variety of polymer materials.

Additional embodiments of the present invention provide polymer composites, including those wherein the polymer composite is in a form having a planar configuration - for example, a film, sheet, or ribbon -- comprising a MXene layer or multilayer composition. Still further embodiments provide such polymer composites wherein the two-dimensional crystal layers of the MXene materials are aligned or substantially aligned with the plane of a polymer composite film, sheet, or ribbon, especially when the organic polymers are oriented in the plane of that film, sheet, or ribbon.

The large elastic moduli predicted by *ab initio* simulation, and the possibility of varying their surface chemistries (beyond those exemplified herein, which are terminated by hydroxyl and/or fluorine groups) render these nanosheets attractive as polymer composite fillers. For example, the elastic modulus of a single, exfoliated $Ti_3C_2(OH)_2$ layer, along the basal plane, is calculated to be around 300 GPa, which is within the typical range of transition metal carbides and significantly higher than most oxides and clays (see, e.g., P. H. Nadeau, Applied Clay Science 1987, 2, 83). And while the 300 GPa value is lower than that of graphene (*e.g.*, as described in S. Stankovich, et al., Nature 2006, 442, 282), the ability to match the character of the MXene layered materials with that of the polymer matrix, as described above, is expected to ensure better bonding to and better dispersion in polymer matrices when these MXene layers are to be used as reinforcements in polymer composites. It is also important to note here that the functionalized $Ti_3C_2$ sheets described herein were much more stable than graphene sheets under the 200 kV electron beam in the TEM.

Accordingly, still further embodiments provide that the MXene composition-filled composite polymers, especially when these polymer composites have a planar configuration, such as that of film, sheet, or ribbon, especially an oriented film, sheet, or ribbon, exhibit a flexural strength (bending rigidity) and/or stiffness than that of the corresponding film, sheet, or ribbon of the same polymer without the MXene composition. In some embodiments, this greater flexural strength and/or stiffness is independently at least 5%, at least 10%, or at least 25% higher than the flexural strength or toughness than that exhibited by an otherwise equivalent, but unfilled material.

Thus far, the compositions of the invention have been described in terms of having individual layers having first and second surfaces, each layer comprising a two-dimensional array of crystal cells. However, the invention provides for stacked assemblies of at least two layers having first and second surfaces, each layer comprising a two-dimensional array of crystal cells, each crystal cell having the empirical formula of $M_{n+1}X_n$, such that each X is positioned within an octahedral array of M; wherein M is a Group IIIB, IVB, VB, or VIB metal; each X is C or N; and n = 1, 2, or 3; and wherein the layers are characterized as having an average surface area and interlayer distance.

In various embodiments of these stacked assemblies, each layer may retain the characteristics as described above, but be held in place or edge-wise connected such that the assembly has up to about 50 layers of crystal layers. In various embodiments, these number of crystal layers in these assemblies may be described as having a range having a lower end of 2, about 5, about 10, about 15, or about 20 and an upper range of about 50, about 40, about 30, about 25, about 20, and about 10, with exemplary ranges of 2 to about 50, 2 to about 25, 2 to about 20, about 5 to about 50, about 5 to about 25, about 5 to about 20, about 10 to about 50, about 10 to about 25, about 10 to about 20, about 10 to about 15, about 15 to about 20.

In various embodiments, the composite layers characterized as having an average surface area. While the bounds of these areas are not necessarily limited to any particular values, in certain preferred embodiments, the average surface or planar area is defined by a range of areas, with individual embodiments having a lower range value of about 50 $nm^2$, about 100 $nm^2$, about 250 $nm^2$, about 500 $nm^2$, , or about 1000 $nm^2$, and having an upper range value of about 10,000 $nm^2$, about 5000 $nm^2$, about 2500 $nm^2$, about 1000 $nm^2$, about 500 $nm^2$, about 250 $nm^2$, or about 100 $nm^2$, with exemplary

ranges of about 100 nm$^2$ to about 2500 nm$^2$, of about 250 nm$^2$ to about 2500 nm$^2$, of about 500 nm$^2$ to about 1500 nm$^2$, of about 500 nm$^2$ to about 1000 nm$^2$, 50 nm$^2$ to about 250 nm$^2$, or about 750 nm$^2$ to about 1000 nm$^2$.

In other preferred embodiments, the average surface or planar area is defined by a range of areas, with individual embodiments having a lower range value of about 5 $\mu$m$^2$, about 10 $\mu$m$^2$, about 25 $\mu$m$^2$, about 50 $\mu$m$^2$, about 100 $\mu$m$^2$, about 250 $\mu$m$^2$, about 500 $\mu$m$^2$, or about 1000 $\mu$m$^2$ and having an upper range value of about 10,000 $\mu$m$^2$ , about 1000 $\mu$m$^2$, about 500 $\mu$m$^2$, about 250 $\mu$m$^2$, about 100 $\mu$m$^2$, about 50 $\mu$m$^2$, about 25 $\mu$m$^2$, or about 10 $\mu$m$^2$, with exemplary ranges of about 10 $\mu$m$^2$ to about 250 $\mu$m$^2$, of about 25 $\mu$m$^2$ to about 250 $\mu$m$^2$, of about 50 $\mu$m$^2$ to about 150 $\mu$m$^2$, of about 50 $\mu$m$^2$ to about 100 $\mu$m$^2$, 5 $\mu$m$^2$ to about 25 $\mu$m$^2$, or about 75 $\mu$m$^2$ to about 125 $\mu$m$^2$.

While the surface of these composite layer may be of any shape, it is convenient to describe such shapes as having a major and minor planar dimension (or x-axis and y-axis dimensions, using the envisioned x-y plane as described above) . For example, if a quadrilateral or pseudo-quadrilateral shape, the major and minor dimension is the length and width dimensions. In preferred embodiments, the ratio of the lengths of the major and minor axes is in the range of about 1 to about 10 (1:10) to about 10 to about 1 (10:1), about 1 to about 5 (1:5) to about 5 to about 1 (5:1), more preferably about 1 to about 3 (1:3) to about 3 to about 1 (3:1), or about 1 to about 2 (1:2) to about 2 to about 1 (2:1).

Additionally, in various embodiments, the interlayer distances (i.e., the distances between the composite crystal layers) in these stacked assemblies is in the range of about 0.2 nm to about 1 nm, preferably in the range of about 0.3 nm to about 0.5 nm. When prepared by the methods described below (i.e., removing the labile A-phase elements from MAX phase materials, see below), these interlayer distances may be consistent with the atomic radii of the removed elements. For example, the atomic diameter of Al is about 0.25 nm and that of Sn about 0.3 nm.

Certain embodiments of the present invention provide stacked assemblies which are capable of intercalating atoms and/or ions between at least some of the layers of two-dimensional crystal layers. For example, these atoms and/or ions can be metal or metalloid atoms or ions, including alkali, alkaline earth, and transition metals. In some embodiments, these are alkali metal atoms and/or ions (e.g., Li, Na, K, and/or Cs); and most preferably lithium. In some embodiments, these atoms and/or ions are able to move into and out of the stacked assemblies.

These multilayer structures or assemblies may be used for the same types of applications described above for the MXene layer compositions.

Additionally, the ability to intercalate lithium atoms and/or ions, together with the electrical properties of the MXene layers described above, provides the opportunities that these stacked assemblies may be used as energy storing devices (e.g., anodes) comprising these intercalated stacked composition, or the energy storage devices themselves, for example, batteries, comprising these elements.

Density functional theory (DFT) calculations at 0 K and in Li-rich environments show that the formation of $Ti_3C_2Li_2$ as a result of the intercalation of Li into the space vacated by the Al atoms (**FIG. 6(c)**) assuming reaction

$$Ti_3C_2 + 2Li = Ti_3C_2Li_2 \qquad\qquad (4)$$

has an enthalpy change of 0.28 eV. One possible reason for the positive value maybe the fact that Li has an atomic radius of 145 pm, whereas that of Al is 125 pm. The structure shown in **FIG. 6(c)** would provide a capacity of 320 mAhg$^{-1}$, which is comparable to the 372 mAhg$^{-1}$ of graphite for ($LiC_6$).

Accordingly, various embodiments of the present invention include Li-ion batteries (FIG. 6(c)) and pseudo-capacitor electrodes, wherein the MXene layers or assemblies replace layered transition metal oxides, which show useful red-ox properties and Li-intercalation, but which have lower electrical conductivities than described herein for the MXene materials.

The ability of MXene to intercalate ions, including lithium ions, so as to allow these materials to act as Li-ion batteries and/or pseudo-capacitor electrodes, is shown in Example 10, below.

In addition to the compositions of the MXene materials, various embodiments provide for the preparation of such materials. Certain embodiments provide methods of preparing compositions comprising: (a) removing substantially all of the A atoms from a MAX-phase composition having an empirical formula of $M_{n+1}AX_n$; wherein M is an early transition metal or a mixture thereof, wherein A is a so-called A-group element (typically described, see below, as including Al, Si, P, S, Ga, Ge, As, Cd, In, Sn, Tl, and Pb); wherein X is C or N, or a combination thereof; and wherein n = 1, 2, or 3 so as to provide a free standing composition comprising a framework of a substantially two-dimensional composite crystal layer having first and second surfaces.

MAX phase compositions are generally recognized as comprising layered, hexagonal carbides and nitrides have the general formula: $M_{n+1}AX_n$, (MAX) where n = 1 to 3, in which M is typically described as an early transition metal (comprising a Group IIIB, IVB, VB, or VIB metal), A is described as an A-group (mostly IIIA and IVA, or groups 13 and 14) element and X is either carbon and/or nitrogen. *See, e.g.,* M.W. Barsoum, et al., "Synthesis and Characterization of a Remarkable Ceramic: Ti3SiC2, " J. Amer. Ceramics. Soc., 79, 1953-1956 (1996); M. W. Barsoum, "The MN+1AXN Phases: A New Class of Solids: Thermodynamically Stable Nanolaminates," Progress in Solid State Chemistry, 28, 201-281 (2000). While $Ti_3AlC_2$ is among the most widely studied of these materials, more than 60 MAX phases are currently known to exist and are useful in the present invention. While not intending to be limiting, representative examples of MAX phase materials useful in the present invention include: (211) $Ti_2CdC$, $Sc_2InC$, $Ti_2AlC$, $Ti_2GaC$, $Ti_2InC$, $Ti_2TlC$, $V_2AlC$, $V_2GaC$, $Cr_2GaC$, $Ti_2AlN$, $Ti_2GaN$, $Ti_2InN$, $V_2GaN$, $Cr_2GaN$, $Ti_2GeC$, $Ti_2SnC$, $Ti_2PbC$, $V_2GeC$, $Cr_2AlC$, $Cr_2GeC$, $V_2PC$, $V_2AsC$, $Ti_2SC$, $Zr_2InC$, $Zr_2TlC$, $Nb_2AlC$, $Nb_2GaC$, $Nb_2InC$, $Mo_2GaC$, $Zr_2InN$, $Zr_2TlN$, $Zr_2SnC$, $Zr_2PbC$, $Nb_2SnC$, $Nb_2PC$, $Nb_2AsC$, $Zr_2SC$, $Nb_2SC$, $Hf_2InC$, $Hf_2TlC$, $Ta_2AlC$, $Ta_2GaC$, $Hf_2SnC$, $Hf_2PbC$, $Hf_2SnN$, $Hf_2SC$; (312) $Ti_3AlC_2$, $V_3AlC_2$, $Ti_3SiC_2$, $Ti_3GeC_2$, $Ti_3SnC_2$, $Ta_3AlC_2$, and (413) $Ti_4AlN_3$, $V_4AlC_3$, $Ti_4GaC_3$, $Ti_4SiC_3$, $Ti_4GeC_3$, $Nb_4AlC_3$, and $Ta_4AlC_3$. Solid solutions of these materials can also be used as described herein (e.g., see Example 4).

MAX phase materials are themselves known to exist as laminated structures with anisotropic properties. These materials are layered hexagonal (space group $P6_3$/mmc), with two formula units per unit cell (**FIG. 1**). Near close-packed M-layers are interleaved with pure A-group element layers, with the X-atoms filling the octahedral sites between the former.

Within the MAX phase structure, the $M_{n+1}X_n$ layers are chemically quite stable, possibly owing to the strength of the M-X bond. By comparison, the A-group atoms are the most reactive species, reflective of their relatively weak binding. For example, heating $Ti_3SiC_2$ in a C-rich atmosphere or heating in molten cryolite or molten aluminum is known to result in the loss of Si and the formation of $TiC_x$. In the case of cryolite, the vacancies that form lead to the formation of a partially ordered cubic $TiC_{0.67}$ phase. In both cases, the high temperatures lead to a structural transformation from a hexagonal to a cubic lattice and a partial loss of layering. In some cases, such as $Ti_2InC$, simply heating in vacuum at $\approx 800°C$, results in loss of the A-group element and $TiC_x$ formation. Removing of both the M and A elements from MAX structure by high temperature chlorination results in a porous carbon known as carbide derived carbon with useful and unique properties.

By contrast, the present methods surprisingly provide for the preparation of compositions comprising layers or stacked assemblies of at least one layer having first and second surfaces, each layer comprising a substantially two-dimensional array of crystal cells, each crystal cell deriving from the $M_{n+1}X_n$ layers of MAX phase compositions. These compositions are free-standing or can be organized into stacked assemblies of coated crystal layers.

As used herein, the term "removing substantially all of the A atoms from a MAX-phase composition" connotes embodiments wherein at least 50 atomic % of the A atoms are removed from a finally recovered sample, relative to the original MAX phase composition. In other more preferred independent embodiments, more than about 60 atomic %, more than about 70 atomic %, more than about 80 atomic %, more than about 90 atomic %, more than about 95 atomic %, more than about 98 atomic %, and more than about 99 atomic % of the A atoms are removed from a finally recovered sample, relative to the original MAX phase composition.

Certain embodiments provide a process for removing these A atoms comprising treatment with an acid, preferably a strong acid capable of reacting with the A atoms. Such acids may be organic or inorganic acids, and may be applied in the gas or liquid phase, provided the resulting A-atom product can be removed from the lattice. In this regard, strong acids which include fluorine atoms appear to be especially preferred. Aqueous hydrofluoric acid is among those acids which appear especially useful. However, the skilled artisan will appreciate that any reactant known to react preferentially with the A atoms of a given MAX phase composition, relative to the $M_{n+1}X_n$ may also be useful, for example selective chelants. Uses of such reactants are considered within the scope of this invention.

The extraction of the A group layers may be done at room, or even moderate, temperature, for example in the range of about 20°C to about 800°C, preferably in temperature ranges wherein the lower temperature is about 20°C, about 25°C, about 30°C, about 40°C, about 50°C, about 60°C, about 80°C, about 100°C , about 200°C, or about 300°C , and wherein the upper temperature is about 600°C, about 500°C, about 400°C, about 300°C, about 250°C, about 200°C, about 150°C, about 100°C, about 80°C, or about 60°C. Exemplary examples of ranges include temperatures in the range of about 20°C to about 100°C, about 20°C to about 60°C, or about 30°C to about 60°C. The extractions may be conducted using liquid or gas phase extraction methods. Gas phase reactions are generally to be done at the higher temperatures.

In further embodiments, the chemically treated materials are subjected to sonication, either using ultrasonic or mega sonic energy sources. This sonication may be applied during or after the chemical treatment.

One embodiment of the chemical exfoliation process for one representative material is diagrammatically illustrated in **FIG. 3,** and described further below. In this example, the treatment of $Ti_3AlC_2$ powders for 2 h in aqueous HF resulted in the formation of exfoliated 2-D $Ti_3C_2$ layers. The term "exfoliated" refers to a process of delaminating the individual (or multiple individual layers) from the stacked assemblies (see, e.g., the second step illustrated in **FIG. 3**). The exposed Ti surfaces appear to be terminated by OH and/or F (see Examples below). While not intending to be bound by the correctness of any single theory or mechanism, based on the experimental information provided below, it appears that the following simplified reactions occur when $Ti_3AlC_2$ is immersed in aqueous HF:

$$Ti_3AlC_2 + 3HF = AlF_3 + 3/2\ H_2 + Ti_3C_2 \qquad (1)$$

$$Ti_3C_2 + 2H_2O = Ti_3C_2(OH)_2 + H_2 \qquad (2)$$

$$Ti_3C_2 + 2HF = Ti_3C_2F_2 + H_2 \qquad (3)$$

Reaction (1) appears to be a necessary step, at least to the extent that it provides for the extraction of $AlF_3$ in some form (e.g., perhaps some soluble derivative, such as $H_3AlF_6$), followed or accompanied by reaction (2) and/or (3). Evidence consistent with the aforementioned reactions and that they result in the exfoliation of 2-D $Ti_3C_2$ layers, with OH and/or F surface groups is presented below. Reactions (2) and (3) are simplified in that they assume the terminations are OH or F, respectively, when in fact they may be a combination of both.

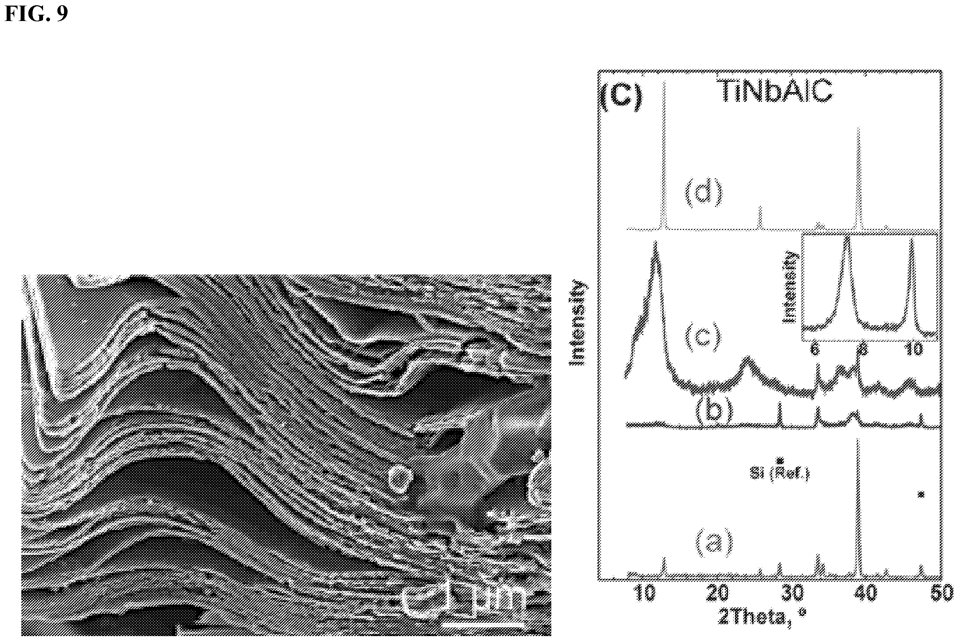

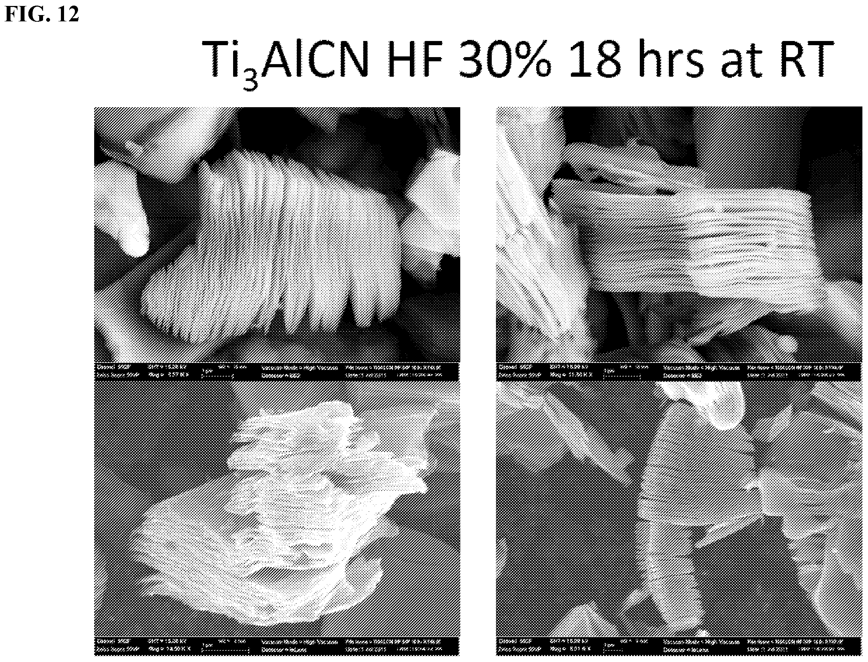

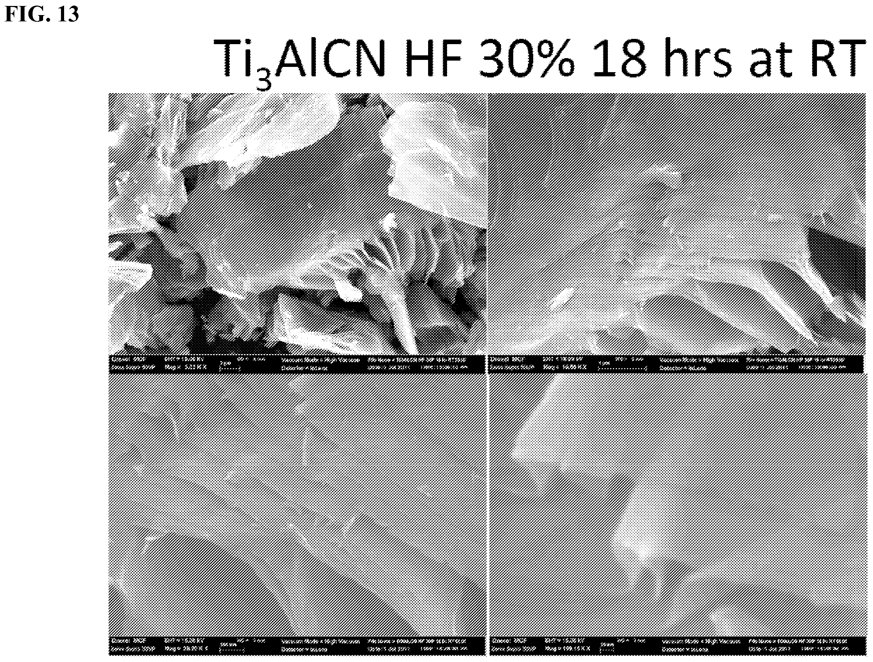

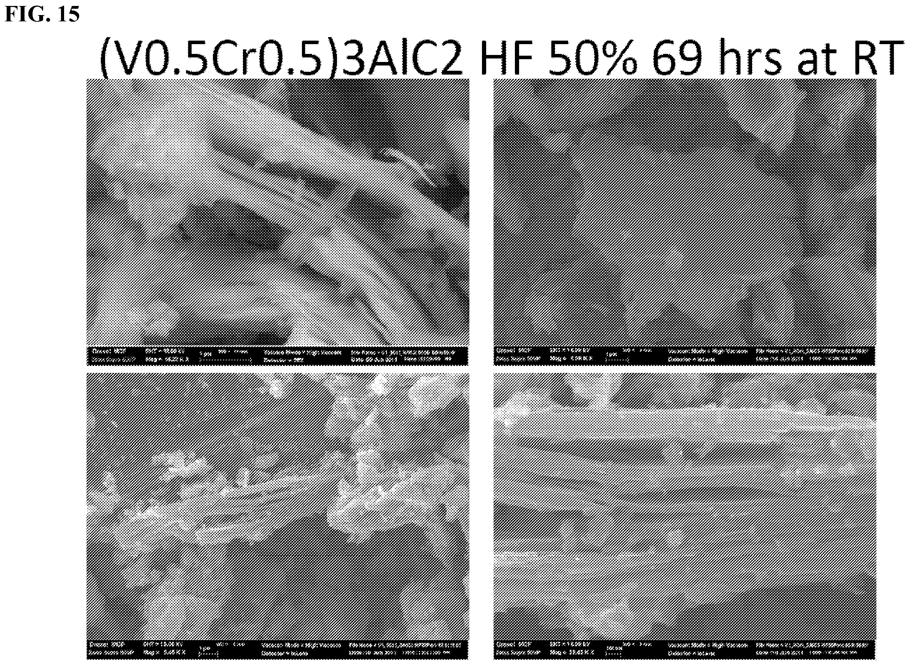

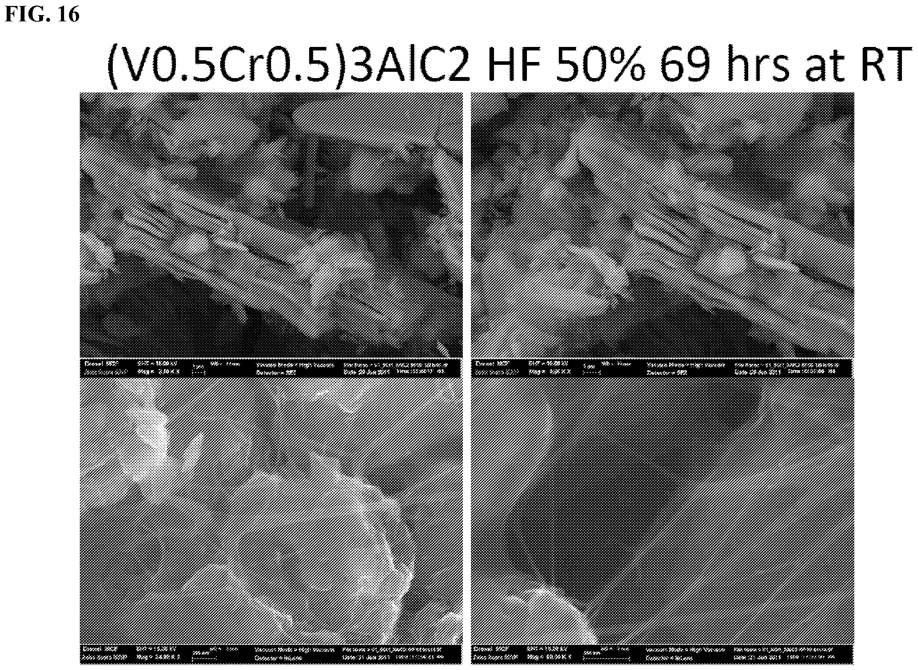

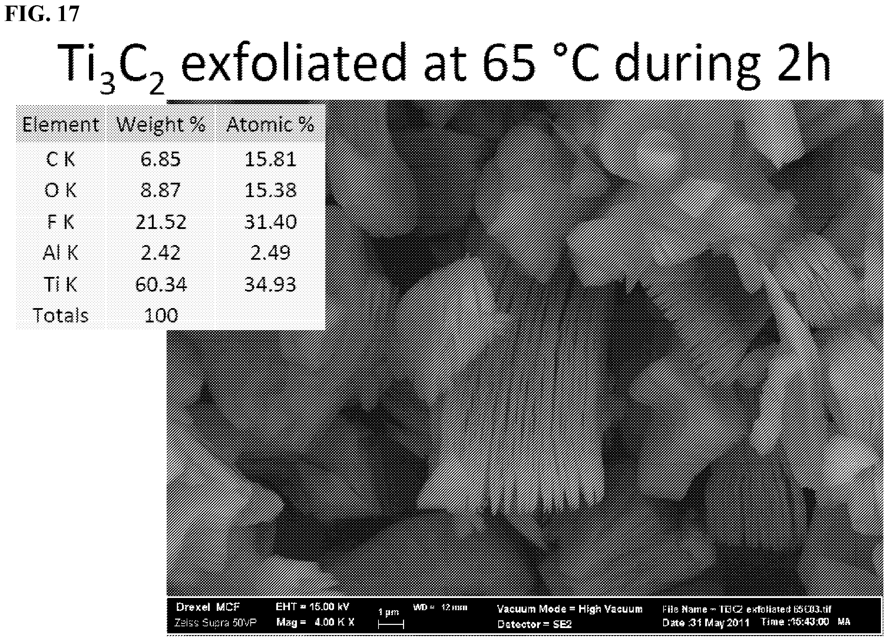

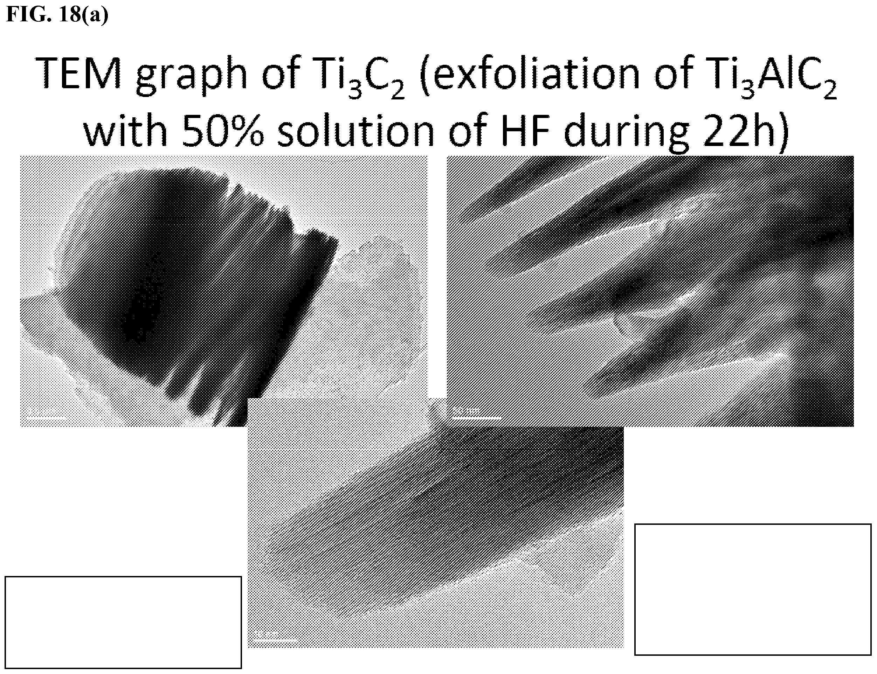

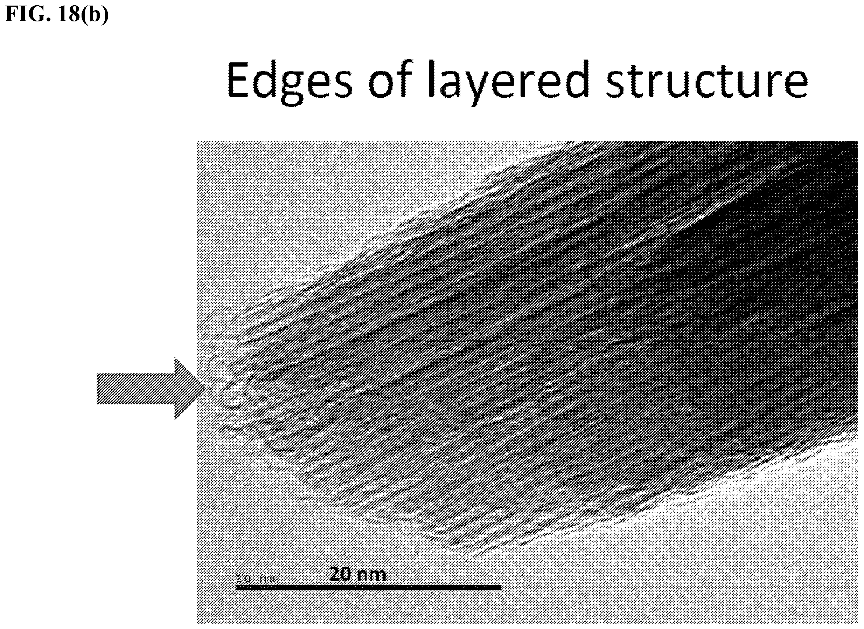

Non-limiting examples of MXene compositions prepared by chemical exfoliation are illustrated in **FIGs. 9-18.**

In other embodiments, the exfoliation can be accomplished electrochemically. In various embodiments, MAX phase materials are selectively exfoliated to form the corresponding MXene by the application of potentiostatic or galvanostatic polarization. See Example 9, below.

It should also be recognized that, in addition to those embodiments described for the compositions provided above, other embodiments provide for compositions provided by the methods of preparation described herein. For example, those composition obtained from subjecting a MAX phase material to a chemical exfoliation process, said exfoliation process comprising treatment with aqueous HF and sonication, wherein a substantial portion of the A atoms are removed should also be considered.

## EXAMPLES

### Example 1: Methods and Materials.

Powder of $Ti_3AlC_2$ was prepared by ball-milling $Ti_2AlC$ (> 92 wt.% 3-ONE-2, Voorhees, NJ) and TiC (99% Johnson Matthey Electronic, NY) powders in a 1:1 molar ratio for 24 h using zirconia balls. The mixture was heated to 1350°C for 2 h under argon, Ar. The resulting loosely held compact was crushed in a mortar and pestle. Roughly 10 g of powders are then immersed in ≈ 100 ml of a 50 % concentrated hydrofluoric acid, HF, (Fisher Scientific, Fair Lawn, NJ) solution at room temperature for 2 h. The resulting suspension was then washed several times using de-ionized water and centrifuged to separate the powders. In some cases, to align the flakes and produce free-standing discs, the treated powders were cold pressed at a load corresponding to a stress of about 1 GPa in a steel die.

X-ray diffraction (XRD) patterns were obtained with a powder diffractometer (Siemens D500, Germany) using Cu $K_\alpha$ radiation, and a step scan of 0.02° and 1 s per step. Si powder was added to some samples as an internal standard. A scanning electron microscope, (SEM, Zeiss Supra 50VP, Germany) was used to obtain high magnification images of the treated powders. Transmission electron microscopes, TEMs, (JEOL JEM-2100F and JEM 2100, Japan; FEI, Tecnai G2 TF20UT FEG, Netherlands) operating at 200 kV were used to characterize the exfoliated powders. Chemical analysis in the TEM was carried out using an ultra-thin window X-ray energy dispersive spectrometer, EDAX (EDAX, Mahwah, NJ). The TEM samples were prepared by deposition of the flakes - from an isopropanol suspension - on a lacey-200 mesh carbon-coated copper grid. Raman spectroscopy of the cold pressed samples was carried out on a microspectrometer (inVia, Renishaw plc, Gloucestershire, UK) using an Ar ion laser (514.5 nm) and a grating with 1800 lines/mm. This corresponds to a spectral resolution of 1.9 $cm^{-1}$ and a spot size of 0.7 $\mu$m in the focal plane. X-ray photoelectron spectroscopy, XPS, (PHI 5000, ULVAC-PHI, Inc., Japan) was used to analyze the surfaces of samples before and after exfoliation.

Theoretical calculations were performed by density functional theory (DFT) using the plane-wave pseudo-potential approach, with ultrasoft pseudopotentials and Perdew Burke Ernzerhof (PBE) exchange - Wu-Cohen (WC) correlation functional, as implemented in the CASTEP code in Material Studio software (Version 4.5). A 8x8x1 Monkhorst-Pack grid and planewave basis set cutoff of 500 eV were used for the calculations. Exfoliation was modeled by first removing Al atoms from the $Ti_3AlC_2$ lattice. Exposed Ti atoms located on the bottom and top of the remaining $Ti_3C_2$ layers were saturated by OH (**FIG. 3(b)**) or F groups followed by full geometry optimization until all components of the residual forces became less than 0.01 eV/Å. Equilibrium structures for exfoliated layers were determined by separating single $Ti_3C_2$ layers by a 1.2 nm thick vacuum space in a periodic supercell followed by the aforementioned full geometry optimization. Band structures of the optimized materials were calculated using a k point separation of 0.015Å$^{-1}$. The elastic properties of the 2-D structures were calculated by subjecting the optimized structure to various strains and calculating the resulting second derivatives of the energy density.

### Example 2: Experimental Characterization of $Ti_3C_2(OH)_2$ and $Ti_3C_2(F)_2$.

XRD spectra of the initial $Ti_2AlC$-TiC mixture after heating to 1350°C for 2 h resulted in peaks that corresponded mainly to $Ti_3AlC_2$ (bottom curve in **FIG. 4(a)**). When the $Ti_3AlC_2$ powders were placed into the HF solution, bubbles, believed to be $H_2$, were observed suggesting a chemical reaction. Ultrasonication of the reaction products in methanol for 300 s resulted in significant weakening of the peaks and the appearance of an amorphous broad band around 24° (top spectrum in **FIG. 4(a)**). In other words, exfoliation leads to a loss of diffraction signal in the out-of-plane direction, and the non-planar shape of the nanosheets results in broadening of peaks corresponding to in-plane diffraction. When the same powders were cold pressed at 1 GPa, into free-standing, 300 $\mu$m thick and 25 mm diameter discs (**FIG. 4(e)**), their XRD showed that most of the non-basal plane peaks of Ti$_3$AlC$_2$ - most notably the most intense peak at $\approx$ 39° - disappear (curve labeled "HF etched" in **FIG. 4(a)**). On the other hand, the (001) peaks, such as the (002), (004) and (010), broadened, lost intensity, and shifted to lower angles compared to their location before treatment. Using the Scherrer formula, as described in B. D. Cullity, Elements of X-ray diffraction, Addison-Wesley 1978, the average particle dimension in the [0001] direction after treatment is estimated to be 1 1$\pm$3nm, which corresponds to roughly ten Ti$_3$C$_2$(OH)$_2$ layers. To identify the peaks we simulated XRD patterns of hydroxylated, viz. Ti$_3$C$_2$(OH)$_2$, (curve labeled "Ti$_3$C$_2$(OH)$_2$" in **FIG. 4(a)**) and fluorinated, Ti$_3$C$_2$F$_2$, structures (curved labeled as such in **FIG. 4(a)**). Clearly, both were in good agreement with the XRD patterns of the pressed sample (curve labeled "HF etched" in **FIG. 4(a)**), the agreement was better with the former. The disappearance of the most intense diffraction peak of Ti$_3$AlC$_2$ at 39° and the good agreement between the simulated XRD spectra for Ti$_3$C$_2$(OH)$_2$ and the experimental results provides strong evidence of the formation of the latter. The presence of OH groups after treatment was confirmed by FTIR.

Further DFT geometry optimization of the hydroxylated (**FIG. 5(f)**) and fluorinated structure resulted in 5% and 16% expansion of the original Ti$_3$AlC$_2$ lattice, respectively, as observed. If Al were simply removed, and not replaced by functional groups, the DFT optimization caused the structure to contract by 19 %, which is not observed. The increase of the c-lattice parameters upon reaction (**FIG. 4(a)**) is thus strong evidence for the validity of reactions 2, 3.

Raman spectra of Ti$_3$AlC$_2$, before and after HF treatment, are shown in **FIG. 4(b).** Peaks II, III, and IV vanished after treatment, while peaks VI and VII, merged, broadened and downshifted. Such downshifting has been observed in Raman spectra of very thin layers of inorganic layered compounds, and is characteristic of such materials. *See, e.g.,* C. N. R. Rao, et al., Science and Technology of Advanced Materials 2010, 11, 0545 02. The line broadening, and the spectral shifts in the Raman spectra are consistent with exfoliation and are in agreement with the broadened XRD profiles. In analogy with Ti$_3$SiC$_2$ (*see* J. Spanier, S. Gupta, M. Amer, M. W. Barsoum, Physical Review B 2005, 71, 012103) peaks I to III in **FIG. 4(b)** can be assigned to Al-Ti vibrations, while peaks V and VI involve only Ti-C vibrations. The fact that only the latter two exist after etching confirms both the mode assignments, but more importantly the loss of Al from the structure. Note that peaks V and VI are combined, broadened and downshifted after reaction.

The Ti 2p XPS spectra, before and after treatment, are shown in **FIG. 4(c).** The C 1s and Ti 2p peaks before treatment match previous work on Ti$_3$AlC$_2$. See, e.g., S. Myhra, et al., Journal of Physics and Chemistry of Solids 2001, 62, 811. The presence of Ti-C and Ti-O bonds was evident from both spectra, indicating the formation of Ti$_3$C$_2$(OH)$_2$ after treatment. The Al and F peaks (not shown) were also observed and their concentrations were calculated to be around 3 at.% and 12 at.%, respectively. Aluminum fluoride (AlF$_3$) - a reaction product, see below - can probably account for most of the F signal seen in the spectra. The O 1s main signal (not shown at -530.3 cm$^{-1}$) suggest the presence of OH group. *See, e.g.,* M. Schmidt, S. G. Steinemann, Fresenius' Journal of Analytical Chemistry 1991, 341, 41 2.

A SEM image of a $\approx$ 1500 $\mu$m$^3$ Ti$_3$AlC$_2$ particle (**FIG. 4(d)**) shows how the basal planes fan out and spread apart as a result of the HF treatment. EDAX of the particles showed them to be comprised of Ti, C, O and F, with little, or no, Al. This implies that the Al layers were replaced by oxygen (i.e. OH) and/or F. Note that the exfoliated particles maintained the pseudo-ductility of Ti$_3$AlC$_2$ and could be easily cold press into freestanding disks (**FIG. 4(e)**). This property can prove crucial in some potential applications, such as anodes for Li-ion batteries, as described above.

TEM analysis of exfoliated sheets (**FIG. 5(a), (b)**) shows them to be quite thin and transparent to electrons since the carbon grid is clearly seen below them. This fact strongly suggests a very thin foil, especially considering the high atomic number of Ti. The corresponding selected area diffraction, SAD (inset in **FIG. 5(b)**) shows the hexagonal symmetry of the basal planes. EDAX of the same flake showed the presence of Ti, C, O, and F. **FIG. 5(c), (d)** show cross-sections of exfoliated single- and double-layer MXene sheets. **FIG. 5(e), (f)** show high-resolution TEM micrographs and a simulated structure of two adjacent OH-terminated Ti$_3$C$_2$ sheets, respectively. The experimentally observed interplanar distances and angles are found to be in good agreement with the calculated structure. **FIG. 6(a), (b)** show stacked multilayer MXene sheets. The exfoliated layers can apparently also be rolled into conical shapes (**FIG. 6(d)**); some are bent to radii of < 20 nm (**FIG. 6(e)**). Note that if Al atoms had been replaced by C atoms, the concomitant formation of strong Ti-C bonds - as when, for example, Ti$_3$SiC$_2$ reacts with cryolite at 900 °C- exfoliation would not have been possible. It follows that the reaction must have resulted in a solid in which the Ti-Al bonds are replaced by much weaker hydrogen or van der Waals bonds. This comment notwithstanding, the EDAX results consistently show the presence of F in the reaction products implying that, as noted above, the terminations are most likely a mixture of F and OH. The presence of up to 12 at.% F has also been confirmed using XPS. In the latter case, however, some of it could originate from AlF$_3$ residue in the sample.

Lastly, it is instructive to point out the similarities between MXene and graphene such as,

(i) the exfoliation of 2-D Ti$_3$C$_2$ layers (**FIG. 6(a)** and **(b)**) into multilayer sheets that resemble exfoliated graphite, see L. M. Viculis, et al., Journal of Materials Chemistry 2005, 15, 974.

(ii) the formation of scrolls (**FIG. 6(d)** and **(e)**).

Also, as cross-sectional TEM (**FIG. 6(e)**) shows, some nanosheets were bent to radii < 20 nm without fracture, which is evidence for strong and flexible $Ti_3C_2$ layers. Similar scrolls were produced by sonication of graphene. See, e.g., L. M. Viculis, et al., Science 2003, 299, 1361; M. V. Savoskin, et al., Carbon 2007, 45, 2797. It is possible that the sonication used for exfoliation caused some nanosheets to roll into scrolls, as schematically shown in **FIG. 6(f)**.

### Example 3: Experimental Characterization of the Product of the Reaction Between $Ta_4AlC_3$ and Aqueous HF - $Ta_4C_3(OH)_x(F)_y$.

$Ta_4AlC_3$ powder (ca. 10 g) was immersed in approximately 100 mL of a 50 % concentrated hydrofluoric acid, HF, (Fisher Scientific, Fair Lawn, NJ) solution at room temperature for 72 h. The resulting suspension was then washed several times using deionized water and centrifuged to separate the powders.

XRD analysis of the resulting material showed sharp peaks corresponding only to TaC, known to be an impurity in the starting material (i.e., in addition to peaks attributable to TaC, the XRD spectrum contained only broad peaks centered around 2θ values of ca. 6° and 34-36°). However, the XRD spectrum of a sample obtained by cold pressing the resulting material, showed strong, albeit broadened peaks at about 2θ = 5.7° and 6.8° (apparently shifted from 2θ - 7.5 in XRD of $Ta_4AlC_3$), smaller peaks at about 2θ = 13° (apparently shifted from 2θ - 15° in XRD of $Ta_4AlC_3$), 26°, and 29°, and broad, albeit low intensity peaks centered at about 2θ = 27-30° and 36°, none of which appear to correspond to TaC, but which are interpreted as being consistent with simulated spectra of $Ta_4C_3(OH)_2$. Compared with the XRD spectra of the original XRD spectrum of $Ta_4AlC_3$ (and its an accompanying pattern simulated by CrystalMaker®), the XRD pattern of the cold-pressed material also showed no evidence of otherwise distinguishing peaks at 2θ - 22°, 29.5°.

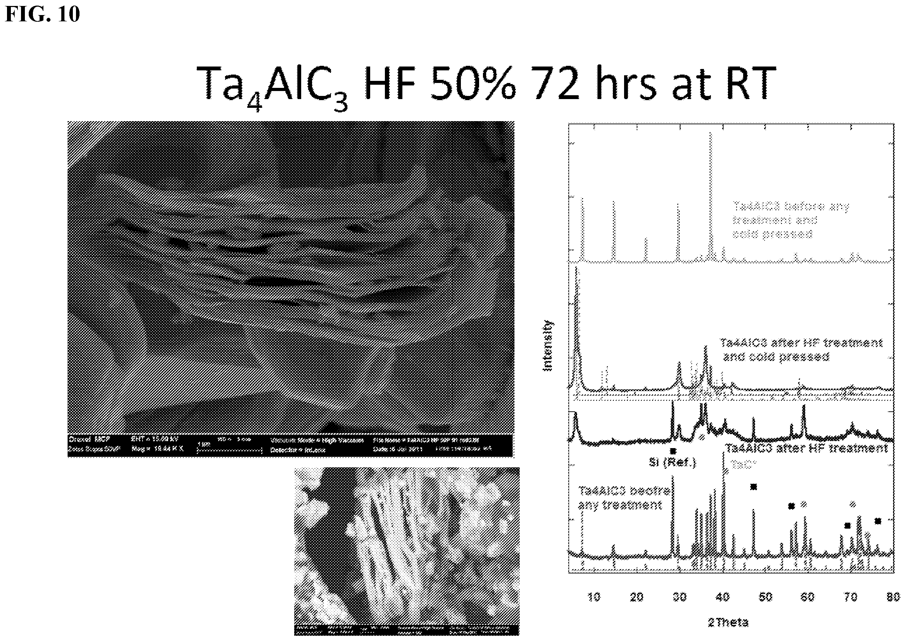

An illustrative XRD spectrum for an exfoliated, characterized to be $Ta_4C_3(OH)_x(F)_y$, are shown in **FIG. 10**.

### Example 4: Experimental Characterization of the Product of the Reaction Between $Ti_2AlC$ and Aqueous HF - $Ti_2C(OH)_x(F)_y$.

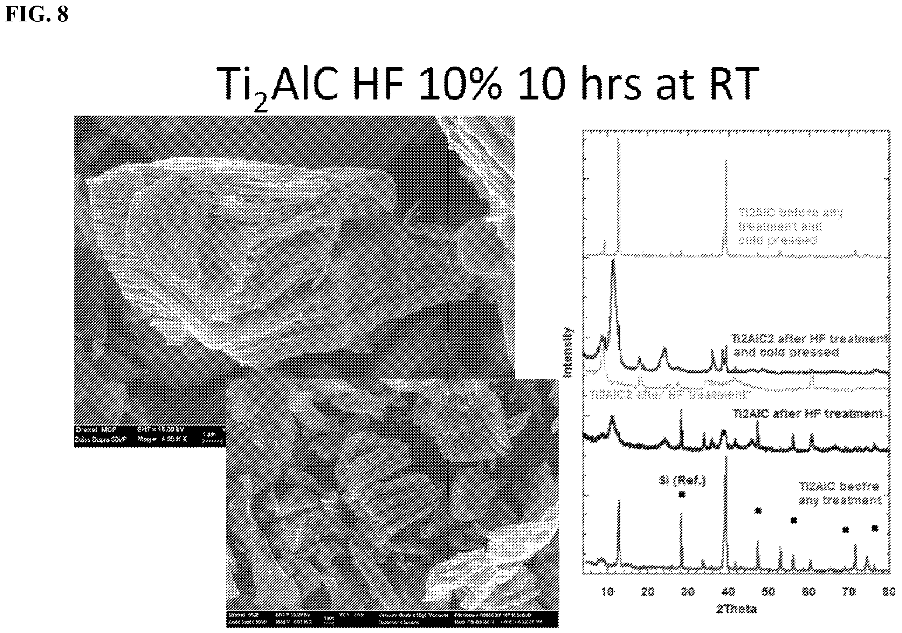

$Ti_2AlC$ powder (Kanthal Corp., Sweden) was immersed in approximately 100 mL of a 10 % concentrated hydrofluoric acid, HF, (Fisher Scientific, Fair Lawn, NJ) solution at room temperature for 10 h. The resulting suspension was then washed several times using deionized water and centrifuged to separate the powders. SEM micrographs and XRD spectra of the resulting materials are shown in **FIG. 8**.

### Example 5: Experimental Characterization of the Product of the Reaction Between TiNbAlC and Aqueous HF) - TiNbC $(OH)_x(F)_y$.

The TiNbAlC powders were made by mixing elemental titanium, Ti (Alfa Aesar, Ward Hill, USA, 99.5 wt % purity; 325 mesh), niobium, Nb (Atlantic Equipment Engineers, Bergenfield, USA, 99.8 wt % purity; 325 mesh), and the same Al and C used above, in the molar ratio of 1:1:1.2:1, respectively, in a ball mill for 12 h. The powders were then heated at the rate of 10°C / min in a tube furnace to 1500°C for 1 h under flowing Ar. After cooling to room temperature, powders were processed as described above (see Table 1). SEM micrographs and XRD spectra of the resulting materials are shown in **FIG. 9**.

The XRD patterns for TiNbAlC, before and after HF treatment (**FIG. 9**), show that the intensity of the TiNbAlC peaks decreased significantly after HF treatment (considering that 10 wt% Si was used as an internal reference) and a new broad peak at ≈11.8° 2θ appeared after cold pressing. Here again a shoulder at a larger d spacing compared to the main peak is observed. The latter is most likely due to some exfoliated $(Ti_{0.5},Nb_{0.5})_3AlC_2$ that was present as a second phase in the starting powder. SEM micrographs (**FIG. 9**) clearly show exfoliated TiNbAlC particles. TEM micrographs, after sonication (not shown), show thin sheets composed of Ti, Nb, C, O, and F in an atomic ratio that EDX shows to be 14:16:23:34:13, respectively. HRTEM of a TiNbC layer (not shown) and its corresponding SAED again show hexagonal symmetry. At 0.2606 nm, the perpendicular separation of the (1010) lattice planes results in an a lattice constant of 0.301 nm. EELS for TiNbAlC after HF treatment and confirms the presence of Ti, Nb, C, F (not shown), and O, but no Al.

Example 6: Experimental Characterization of the Product of the Reaction Between $(V_{1/2}Cr_{1/2})_3AlC_2$ and Aqueous HF) - $(V_{1/2}Cr_{1/2})_3C_2(OH)_x(F)_y$.

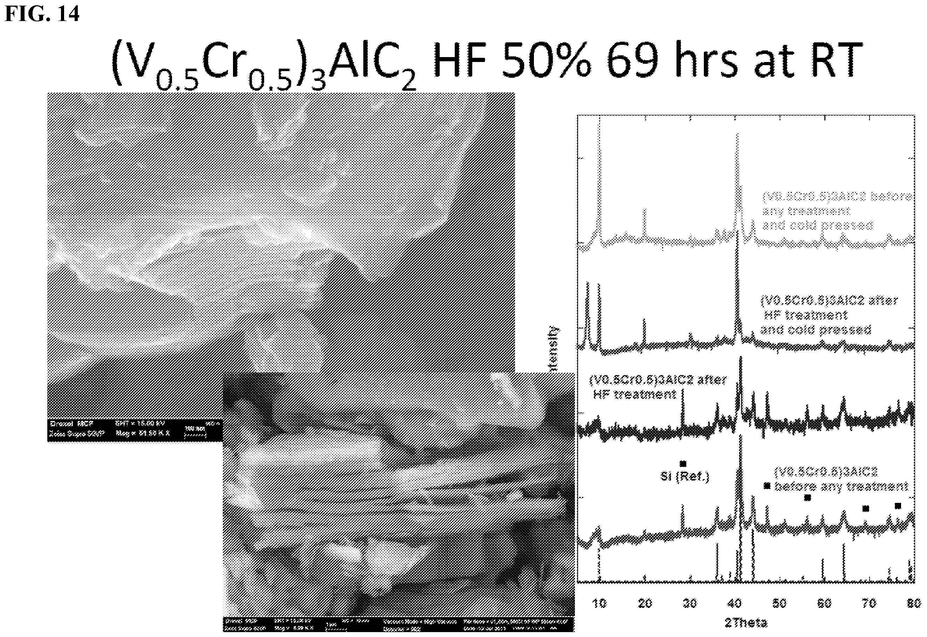

$(V_{1/2}Cr_{1/2})_3AlC_2$ powder was made by ball milling powders of 1.5V+1.5Cr+1.2Al+2C (molar ratios) for 12 hours, then heating the mixture under Ar to 1550°C, soaking at this temperature for 2 hours, and cooling to room temperature, after which a powder was obtained from the sintered mass using diamond coated milling bit. The powders were then exfoliated by stirring them in 50% aqueous HF at room temperature for 65 hr (5 gm powder in 50 mL acid). SEM micrographs and XRD spectra of the resulting materials are shown in **FIGs. 14-16**.

Example 7: Experimental Characterization of the Product of the Reaction Between Ti$_3$**Al(CN)** and Aqueous HF - Ti$_3$ **(CN)**(OH)$_a$(F)$_b$.

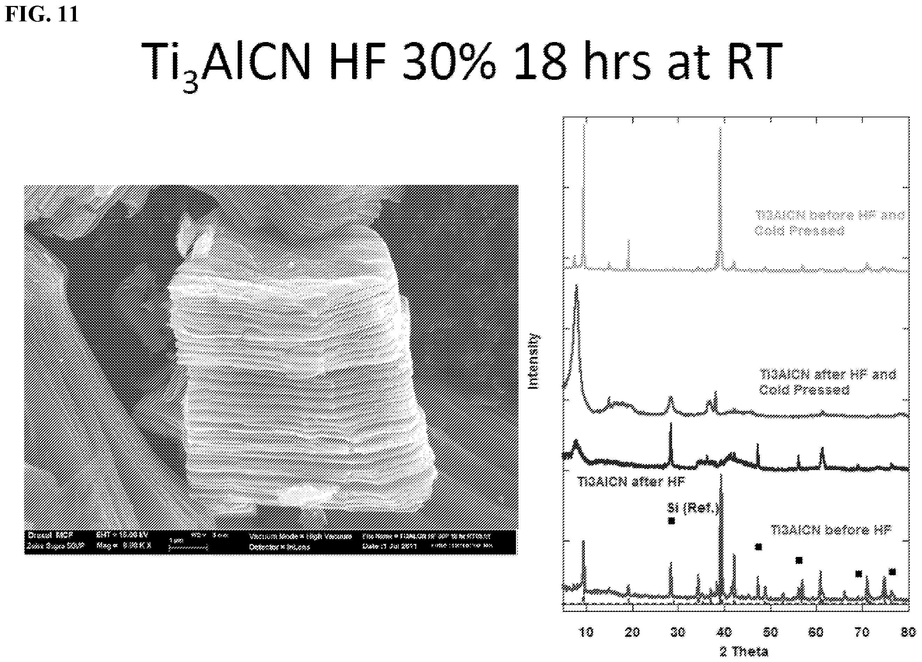

Ti$_3$Al(CN) powder was prepared was made by ball milling Ti:AlN:C = 3:1:1 (molar ratios) for 12 hours, then heating the mixture at 10°C/min to 1500°C, holding 2 hours, then cooling, all under Argon (C and Ti powders were purchased from Alfa Aesar, Ward Hill, MA). AlN powder was purchased from Sigma-Aldrich. The resulting material was crushed using mortar and pestle. The resulting powder was immersed and stirred in 30 % concentrated hydrofluoric acid, HF, (Fisher Scientific, Fair Lawn, NJ) solution at room temperature for 18 h. The resulting suspension was then washed several times using deionized water and centrifuged to separate the powders. SEM micrographs and XRD spectra of the resulting materials are shown in **FIGs. 11-13.**

Example 8: Effect of Chemical Exfoliation Processing Conditions on Formation and Yield of MXene Compositions.

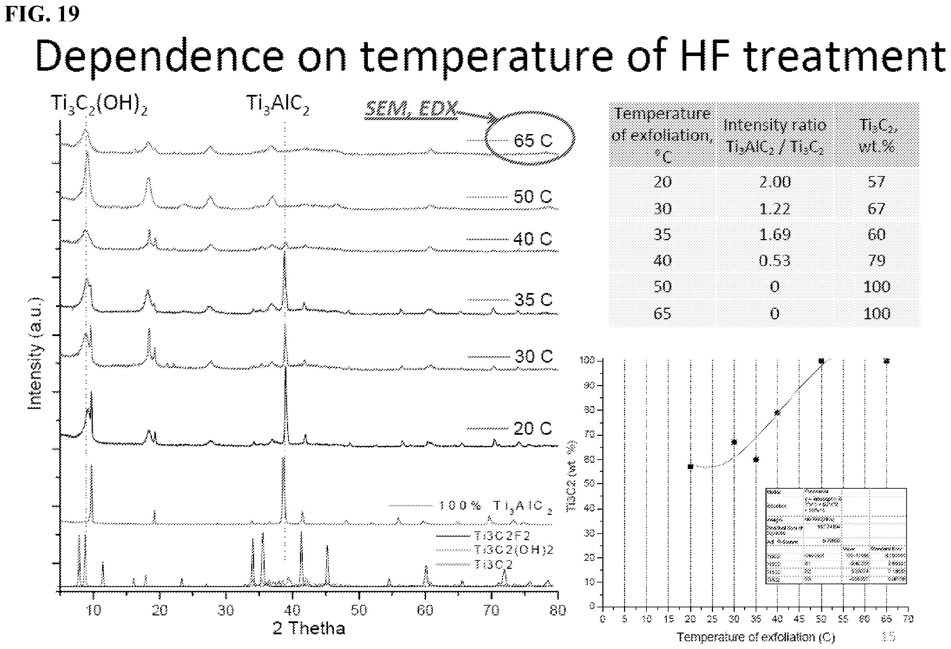

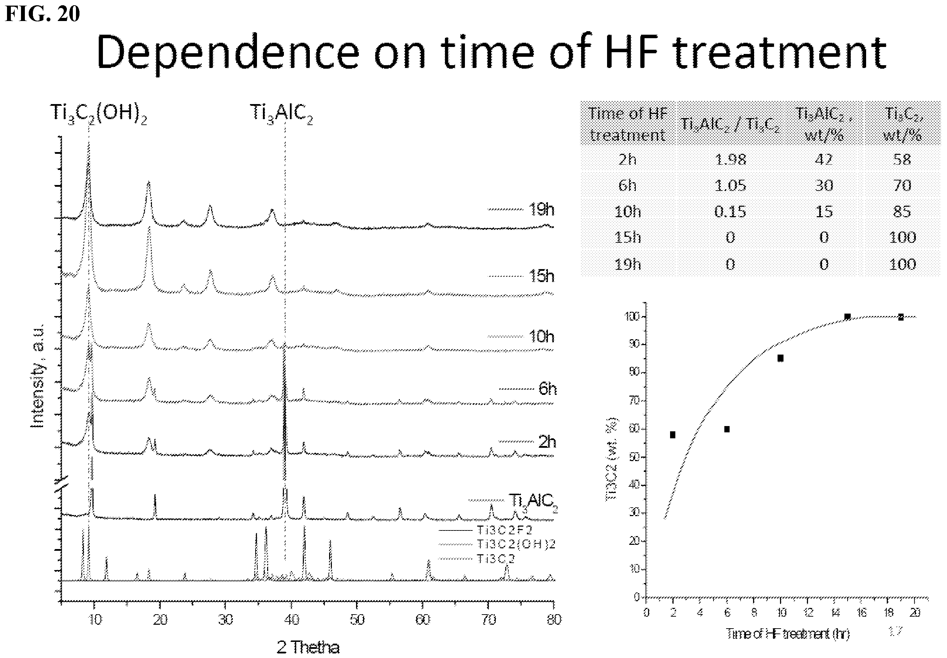

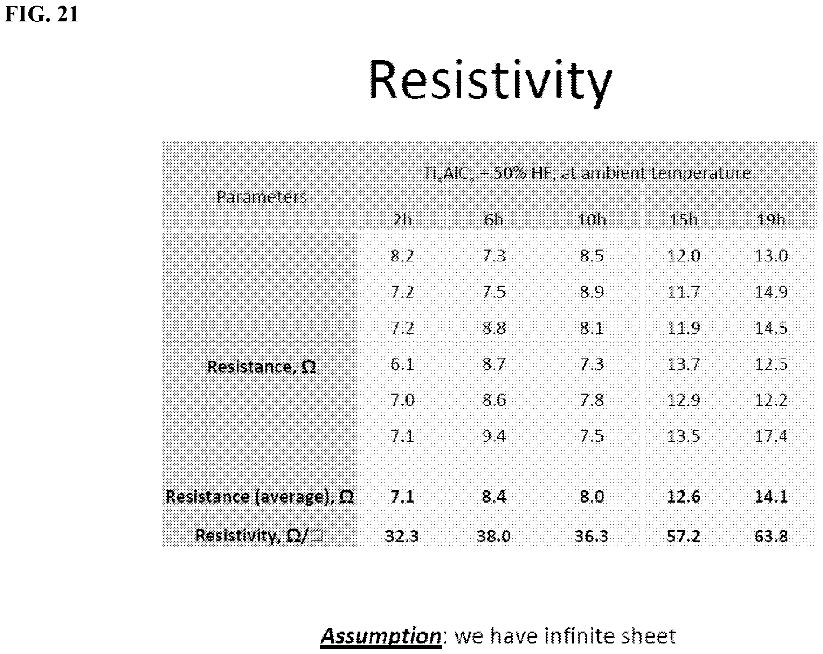

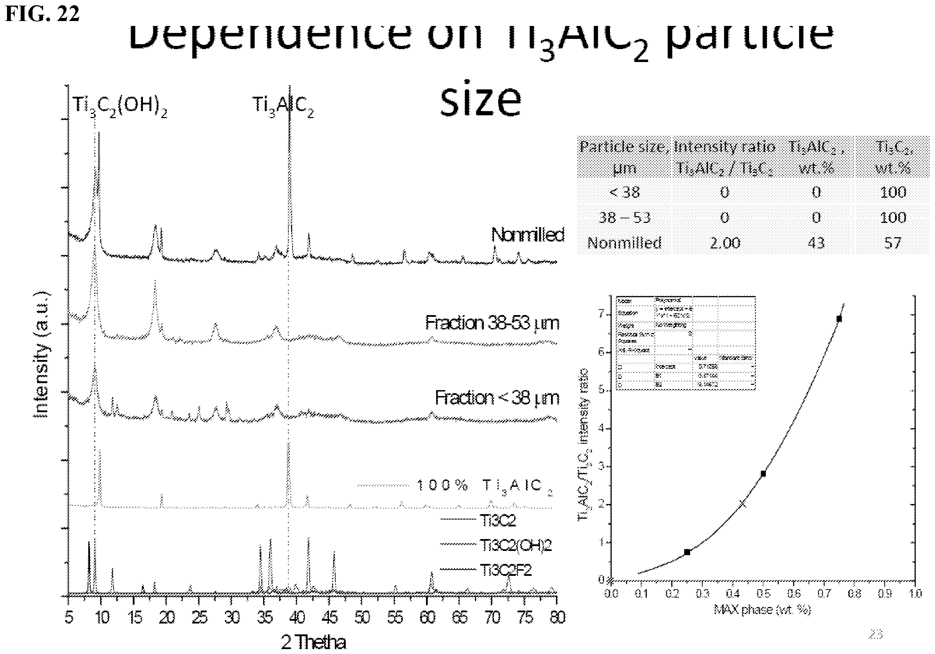

Starting with Ti$_3$AlC$_2$ powders as a representative material, a series of experiments were conducted to determine the effects of various process parameters on the chemical exfoliation of MAX phase materials to form the corresponding MXene compositions. In evaluating the effect of temperature on exfoliation, Ti$_3$AlC$_2$ powders were stirred in 50% aqueous HF for 2 hours at different temperatures (e.g., 20, 30, 40, 50, and 65°C). The effect of processing time was studied by stirring Ti$_3$AlC$_2$ powders with 50% aqueous HF for 2 hours at room temperature over the time range of 2 to 19 hours. In testing the effect of initial particle size, Ti$_3$AlC$_2$ powders were crushed in ball milling machine and separated with sieves first, then exfoliated by stirring with 50% aqueous HF at room temperature for 2 hours. **FIGs. 19, 20, 21,** and **22** illustrate the effect of HF temperature, time of treatment, and initial particle size, respectively. The specific conditions employed, where different than those described above, are provided in each figure.

| TABLE 1. List of MAX Phases Exfoliated in This Work and Exfoliation Process Parameters[a] | | | | | | |
|---|---|---|---|---|---|---|
| | | | *c* lattice constant (nm) | | | |
| Compound | HF Conc (%) | Time (hr) | Before HF | After HF | Domain size (nm) | Yield (wt%) |
| Ti$_2$AlC | 10 | 10 | 1.36 | 4.504 | 6 | 60 |
| Ta$_4$AlC$_3$ | 50 | 72 | 2.408 | 3.034 2.843 | 38 18 | 90 |
| TiNbAlC | 50 | 28 | 1.379 | 1.488 | 5 | 80 |
| (V$_{0.5}$Cr0$_{.5}$)$_3$AlC$_2$ | 50 | 69 | 1.773 | 2.426 | 28 | NA |
| Ti$_3$AlCN | 30 | 18 | 1.841 | 2.228 | 7 | 80 |
| Ti$_3$AlC$_2$ | 30 | 2 | 1.842 | 2.051 | 11 | 100 |
| [a] The particle size for all MAX phases was <35 μm prior to exfoliation. The effects of HF treatment on the c lattice constant and the average domain size along [0001] deduced from the FWHM and the Scherrer formula are listed. The penultimate column shows the estimated process yields. The last column lists the figures associated with each compound. | | | | | | |

Example 9: Preparation of MXene Compositions by the Electrochemical Exfoliation of MAX Phase Materials.

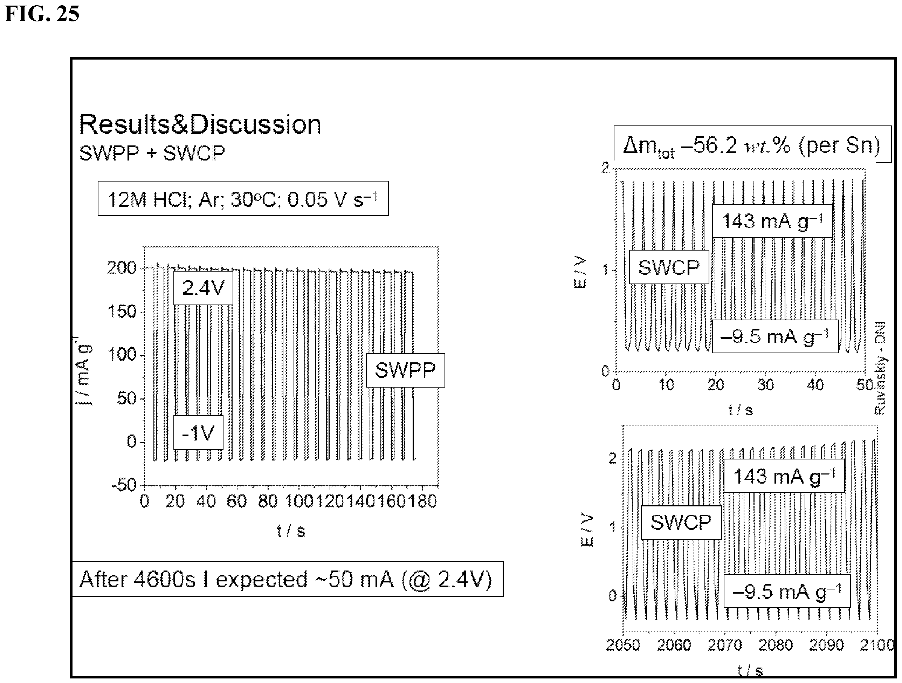

Ti$_2$SnC was made by ball milling 2Ti+Sn+C (molar ratios) for 12 hr, then heating the mixture at a ramp rate of 10°C/minute to 1250°C, holding for 2 hours and cooling to room temperature, all under Ar atmosphere. The resulting material was crushed using mortar and pestle to form a powder (Ti, Sn, and C powders were purchased from Alfa Aesar, Ward Hill, MA). Exfoliation of Ti$_2$SnC was demonstrated by selectively electrochemically removing Sn upon application of a repeated sequence composed of a short cathodic polarization (either potentiostatic or galvanostatic) followed by a long anodic polarization (either potentiostatic or galvanostatic) to an electrochemical system (see **FIG. 25** for a representative set of conditions; SWPP = square wave potential polarization; SWCP = square wave current polarization. $\Delta m_{tot}$ refers to the loss in sample weight as a result of the electrochemical treatment). In this system, a hot pressed sample of Ti$_2$SnC was used as the anode, and Pt was used as the reference and working electrode. The electrolyte was either aqueous 5 M or 12 M HCl, and high purity Ar gas was constantly purged through the working solution to maintain an inert atmosphere.

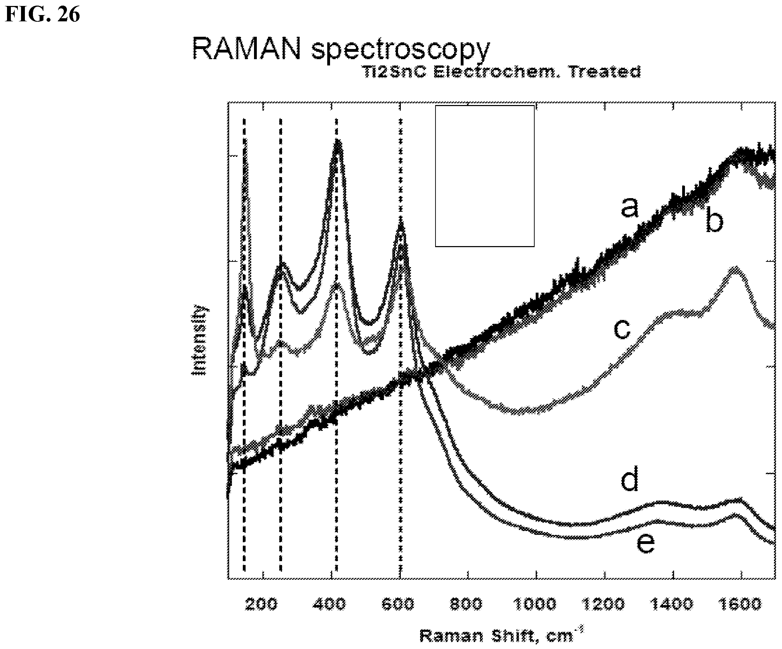

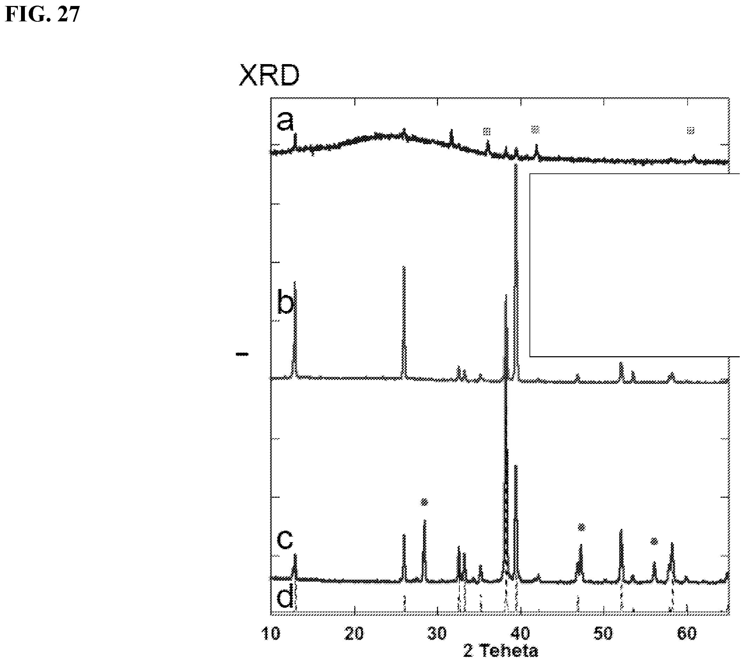

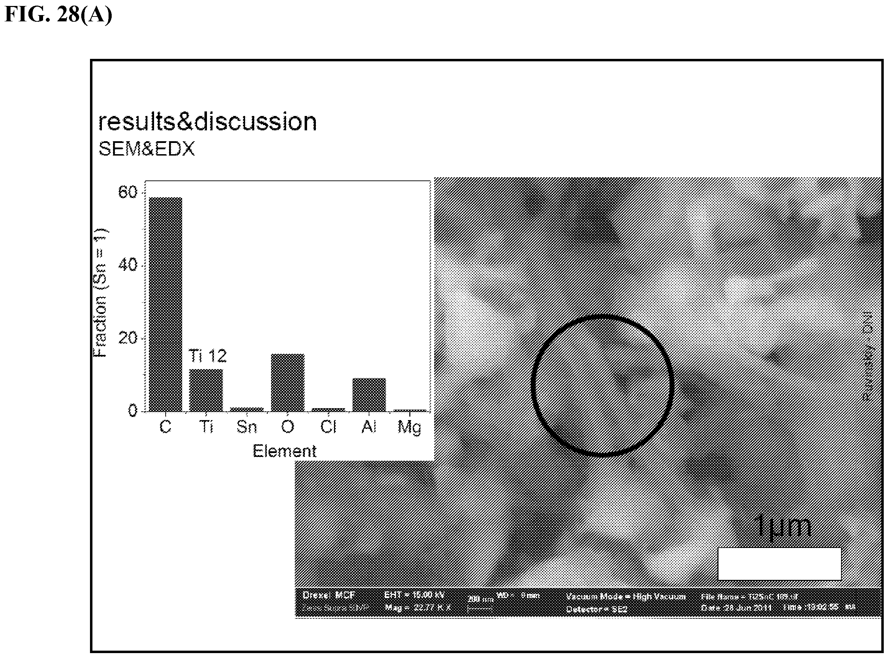

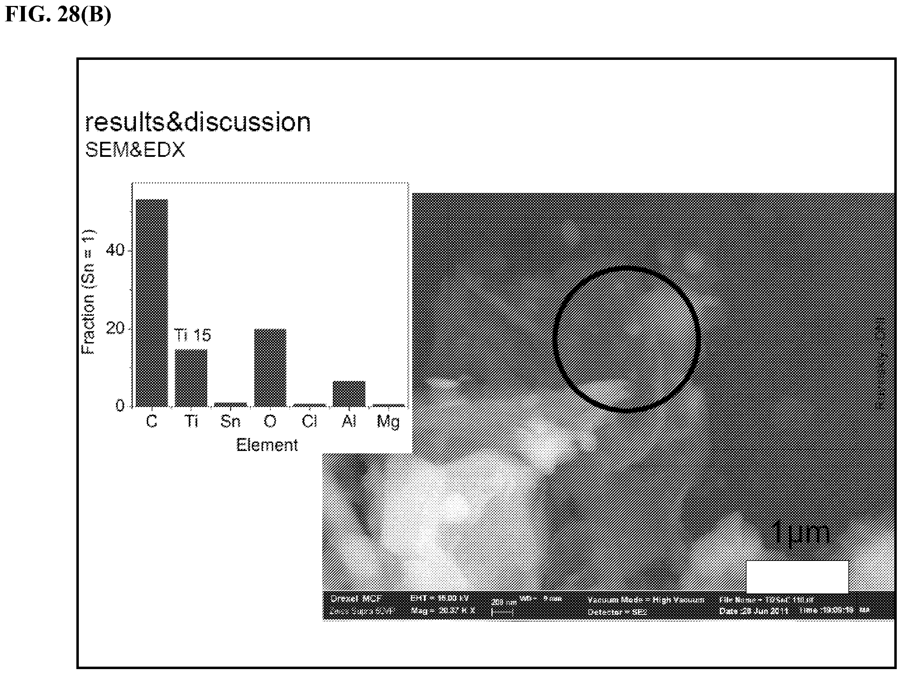

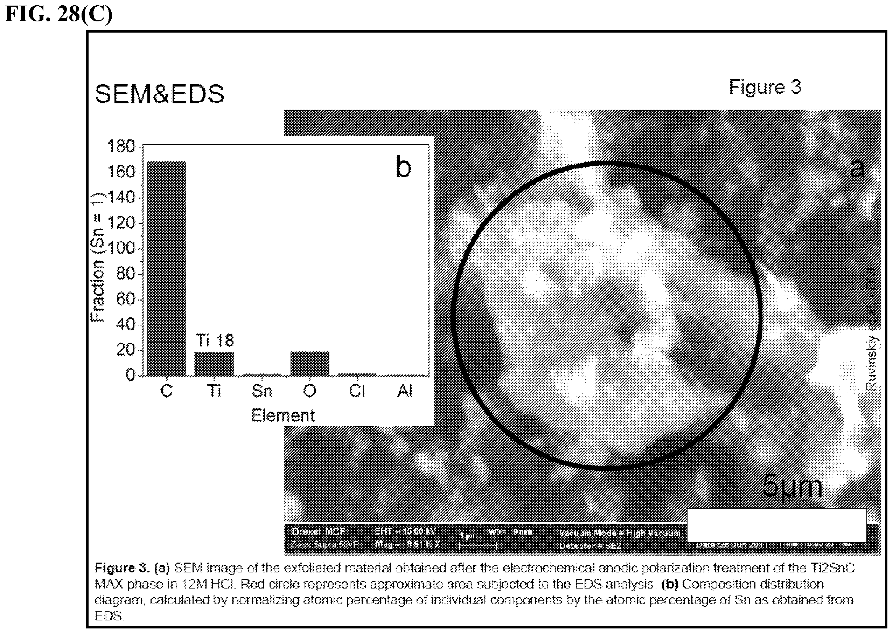

The rapid electrochemical corrosion of the anode material resulted in the formation of a finely dispersed powder which was collected at the bottom of the reaction vessel, washed with deionized water, and dried. The dried powder was subjected to a series of tests, the results of which are shown in **FIGs. 25-28. FIG. 26** shows the dramatic difference in Raman spectra between the product (curves a and b) and the starting material (curves c-e), consistent with the changes seen in other similar transformations (compare, for example, the curves in **FIG. 4(b)**). Similarly, changes in the XRD spectra (**FIG. 27**) are indicative of the absence of starting material. Finally, EDX spectra shown in **FIG. 28(A-C)** show that the powder is devoid of appreciable Sn, confirming its elimination (Note: the presence of O in these EDX spectra is consistent with a surface coating of the MXene comprising oxide or hydroxide. The presence of Si in the spectra is attributed to the substrate used in the measurement.

Example 10: Intercalation of Lithium and Use of $Ti_3C_2$ in Batteries

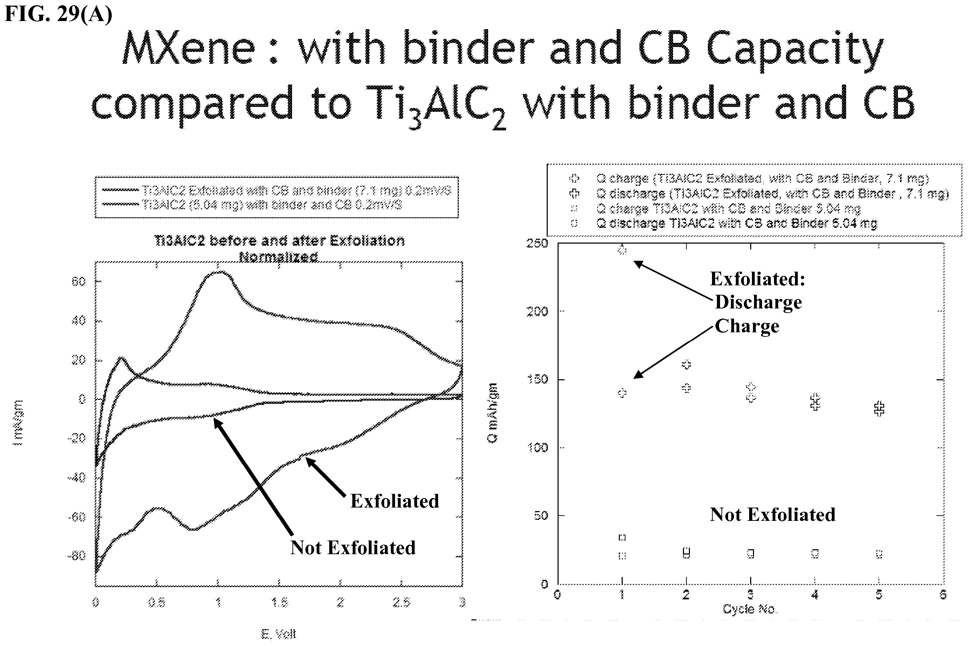

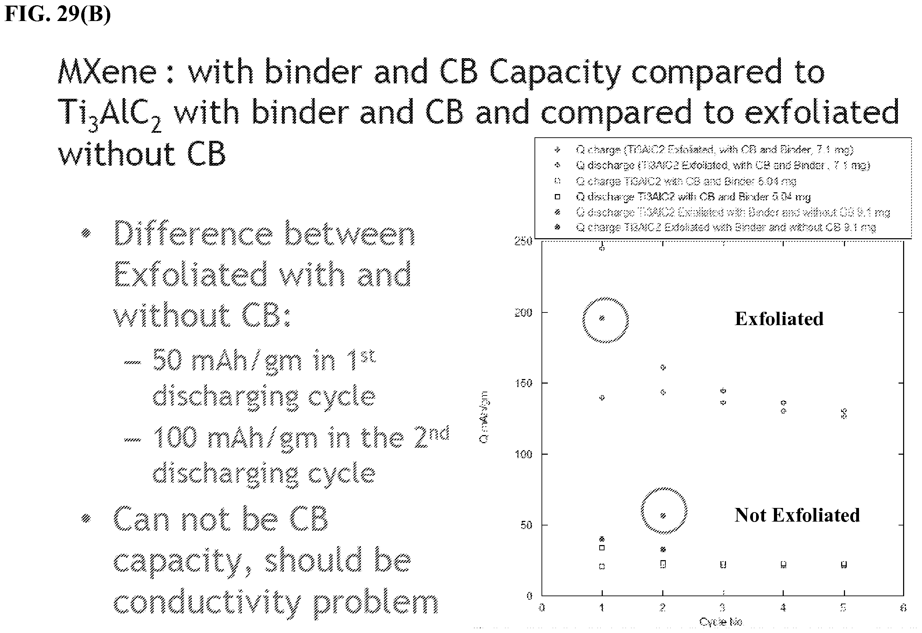

The electrochemical behavior of MXene compositions (exfoliated MX phase compositions) was compared to the corresponding MAX phase material in lithium ion battery tests. [The electrolyte used was a mixture of ethylene carbonate and dimethyl carbonate (EC/DMC) with lithium hexafluorophosphate ($LiPF_6$). After cell assembly inside a glove box, both Galvanostatic (GV) and Cyclic Voltammetry (CV) tests were used to study the electrochemical behavior of MAX phases in Li batteries. These electrochemical tests were carried out using a BioLogic VMP-4 potentiostat/galvanostat.] Electrodes were prepared using MAX phase and MXene compositions in a number of electrode configurations, including (a) cold pressed electrode with neither binder nor carbon black; (b) film of powder on copper foil with binder and without carbon black; (c) film f powder on copper foil with binder and carbon black; and (d) film of carbon black alone with a polyvinylidene-difluoride, PVDF, binder. CV and GV techniques were used to characterize the electrochemical nature of the resulting electrodes / cells. **FIG. 29(A/B)** shows the results where the performance of electrodes prepared using carbon black (CB) and binder, comparing the additional presence of $Ti_3AlC_2$ and exfoliated $Ti_3AlC_2$; i.e., MXene $Ti_3C_2(OH)_x(F)_y$. As shown in **FIG. 29,** the capacity of the MXene containing compositions showed significantly higher capacity an order of magnitude higher) than a comparable electrode made from the corresponding MAX phase material. It is known that lithium capacity in MAX phase materials is extremely low, owing to the lack of space between the layers into which ions may migrate. The significant increase in capacity with the electrodes containing the MXene composition results are consistent with the migration / intercalation of lithium within the stacked layers of MXene

Example 11: Intercalation of Lithium and Use of $Ti_2C$ in Batteries

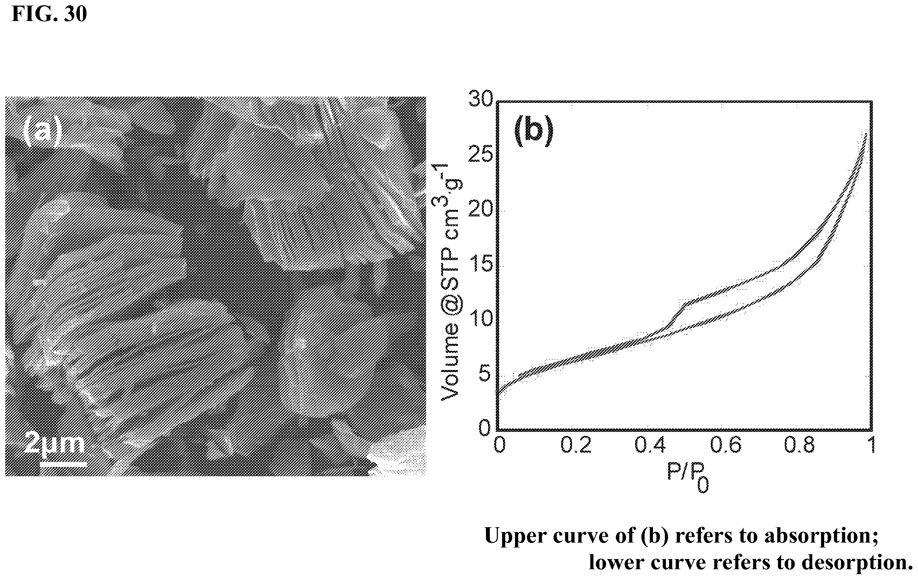

Testing comparable to that described in Example 10 with $Ti_3C_2$ (derived from $Ti_3AlC_2$) was also done with $Ti_2C$ derived from $Ti_2AlC$. As described below, testing demonstrated the insertion of Li into a new two-dimensional (2-D) layered $Ti_2C$-based material (MXene) with an oxidized surface, formed by etching Al from $Ti_2AlC$ in HF at room temperature. Nitrogen sorption of treated powders showed desorption hysteresis consistent with the presence of slit-like pores. At 23 $m^2 \cdot g^{-1}$, the specific surface area was an order of magnitude higher than untreated $Ti_2AlC$. Cyclic voltammetry exhibited lithiation and delithiation peaks at 1.6 V and 2 V vs. $Li^+/Li$, respectively. At C/25, the steady state capacity was 225 $mAh \cdot g^{-1}$; at 1C, it was 110 $mAh \cdot g^{-1}$ after 80 cycles; at 3C, it was 80 $mAh \cdot g^{-1}$ after 120 cycles; at 10C, it was 70 $mAh \cdot g^{-1}$ after 200 cycles.
Pre-reacted, -325 mesh, $Ti_2AlC$ powders were commercially obtained (3-ONE-2, Voorhees, NJ, > 92 wt.% purity). The exfoliation process was carried by immersing the $Ti_2AlC$ powder in diluted (10%) hydrofluoric acid, HF, (Fisher Scientific, Fair Lawn, NJ) for 10 h at room temperature, as described above. The materials were characterized by SEM (Zeiss Supra 50VP, Germany), EDS (Oxford Inca X-Sight, Oxfordshire, UK), and gas sorption analysis (Quantachrome Autosorb-1 with $N_2$ adsorbate) as described above (i.e., samples were outgassed under vacuum at 200 °C for 48 h. Nitrogen sorption analysis at 77 K was used for calculating the specific surface area (SSA) using the Brunauer- Emmet-Teller (BET) equation).
X-ray diffraction, XRD, of the reacted powders indicated that the Al was selectively etched from the structure. EDS confirmed that the Al layers were replaced by O and F. SEM images of $Ti_2AlC$ particles after HF treatment (**FIG. 30(a)** resemble images of exfoliated graphite and clearly show HF-induced delamination that are typical of MXenes.
The $N_2$ sorption isotherm of the treated powders (**FIG. 30(b)** has a hysteresis loop with indications of the presence of mesopores and a shape typical for slit pores. The SSA calculated using the BET equation, for the HF treated $Ti_2AlC$ was 23 $m^2 \cdot g^{-1}$. This value is about an order of magnitude times higher than the as-received $Ti_2AlC$ powders measured at $\approx$2.5 $m^2 \cdot g^{-1}$.
The electrochemical behavior of exfoliated $Ti_2AlC$ in Li batteries was investigated using coin cells (CR 2016) prepared as follows. The working electrodes were made with 80 wt% $Ti_2C$ (as described above) and 10 wt.% Super P carbon black mixed with 10 wt.% Poly(vinylidene fluoride) dissolved in 1-Methyl-2-pyrrolidinone. The mixture was then spread onto a copper foil and dried at ca. 200°C for 12 h, under a mechanical vacuum. CR 2016 coin-type cells were assembled using MXene as the positive electrode and Li metal foil as the negative electrode, separated by a sheet of borosilicate glass fiber (Whatman GF/A) separator saturated with 1 M $LiPF_6$ solution in a 1:1 weight mixture of ethylene carbonate and diethyl carbonate (EC:DEC) as the electrolyte. The cells were assembled inside an Ar-filled glove box with $H_2O$ and $O_2$ contents < 1 ppm, to avoid any moisture contamination.

The cells were subjected to cyclic voltammetry and galvanostatic charge-discharge cycling using a potentiostat (VMP4, Biologic, S.A.). Electrochemical characterization was typically performed between 0.05 V and 2.5 V vs. Li$^+$/Li.

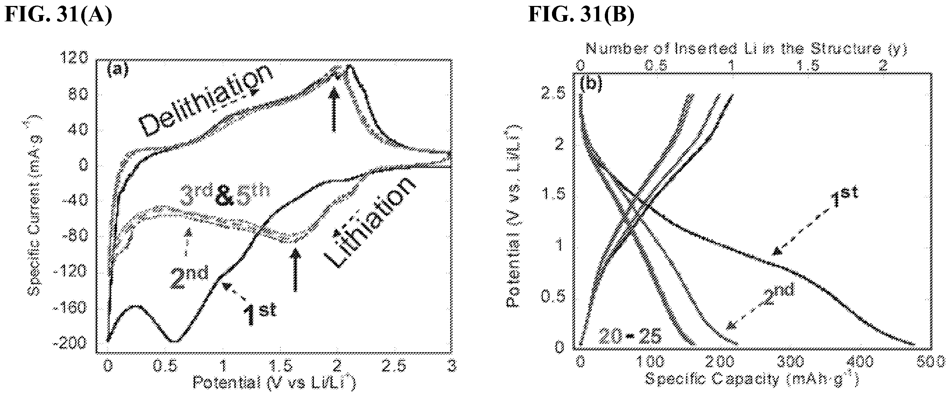

Typical cyclic voltammetry curves, at a rate of 0.2 mV·s$^{-1}$, for the exfoliated Ti$_2$C are shown in **FIG. 31(a).** A broad, irreversible peak was observed around 0.6 V, during the first lithiation cycle (reduction); it was absent in subsequent cycles. This irreversible peak was assigned to the formation of a solid electrolyte interphase (SEI) and to an irreversible reaction with the electrode material. In all subsequent cycles, broad reversible peaks were observed at 1.6 V and 2.0 V vs. Li$^+$/Li during lithiation and de-lithiation, respectively. Because these peak potentials are similar to those reported for TiO$_2$ and lithiated titania, these peaks were tentatively assigned to the following redox reaction:

$$Ti_2CO_x + yLi^+ + ye^- \leftrightarrow Li_yTi_2CO_x \qquad (1)$$

The rationale for this assignment is that drying at 200 °C, prior to assembling the coin cells, rids MXene of water or any OH species and leads to an oxygen terminated surface. In other words, the assumption is made that the Ti$_2$CO$_x$ surface is similar to that of titania. Like in the case of the titanates, even if the potentials vs. Li are relatively high, it is an advantage from a safety stand point. *Ex situ* XRD results (not shown) after lithiation produced no new peaks, but a downshift of the MXene peaks was observed, with an increase of the c parameter by 19.5% which indicates intercalation of Li between the MXene layers, and not a conversion reaction.

**FIG. 31(b)** shows the galvanostatic charge/discharge curves at a rate of C/10 (1 Li$^+$ per formulae exchanged in 10 h). The capacity loss in the first cycle can again be attributed to a SEI layer formation at potentials below 0.9V vs. Li$^+$/Li, as well as to the irreversible reduction of electrochemically active surface groups such as fluorine or possibly hydroxyls. The specific capacity stabilized after five cycles at ≈ 160 mAh·g$^{-1}$. This value corresponds to y ≈ 0.75 in reaction 1.

At 160 mAh·g$^{-1}$, the capacity of the treated powders is about 5 times higher than that of the as-received Ti$_2$AlC (ca. 30 mAh·g$^{-1}$ at C/10) powders. This increase in capacity is traceable to the higher surface area, more open structure and weaker bonds between the MX layers after HF treatment. In addition to the morphological changes, the Li insertion sites are also now different (i.e. the site binding energies) which could also explain the differences in capacity.

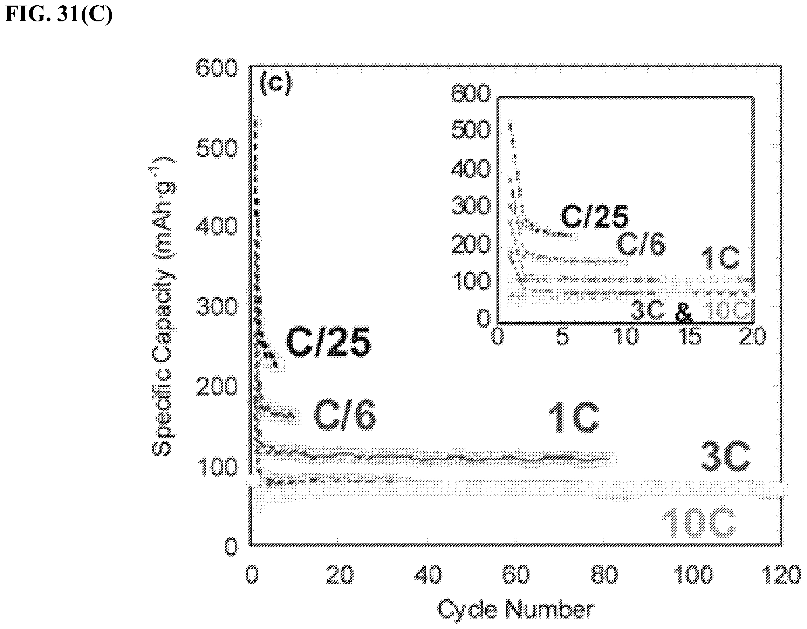

The specific capacities vs. cycle number at different cycling rates (C/25, C/6, 1C, 3C, and 10C) calculated from galvanostatic curves are shown in **FIG. 31(c).** The highest capacity was obtained at a rate of C/25. The specific capacity values stabilize after 5 cycles, for all scan rates. At a C/25 rate, the capacity is 225 mAh·g$^{-1}$, which corresponds to y ≈ 1. At rates of 1 C and 3 C, the capacities, after 80 cycles, were, respectively, 110 mAh·g$^{-1}$ and 80 mAh·g$^{-1}$. Even at rates of 10C, a stable capacity of 70 mAh·g$^{-1}$ was obtained for more than 200 cycles. These results clearly demonstrate that it is possible to stably electrochemically intercalate Li$^+$ ions in the interlayer spaces between exfoliated Ti$_2$C sheets, and achieve stability.

The exfoliated Ti$_2$C, produced by HF treatment of Ti$_2$AlC powders, showed reversible capacity about 5 times higher than pristine Ti$_2$AlC, due to its open structure, weaker interlaminar forces, and higher SSA. Electrochemical measurements showed intercalation and deintercalation of Li$^+$ ions at 1.6 V and 2 V vs. Li$^+$/Li, respectively. The exfoliated Ti$_2$C material exhibited a stable capacity of 225 mAh·g$^{-1}$ at a C/25 rate, corresponding to about one Li per Ti$_2$CO$_x$ formula unit. A stable cycling capacity of 80 mAh·g$^{-1}$ was observed after 120 cycles at a 3C rate, and 70 mAh·g$^{-1}$ was observed after 200 cycles at a 10C rate.

Example 12: Intercalation of Lithium and Use of Other MXenes in Batteries

Similar experiments with Ti$_3$CN, TiNbC, and Ta$_4$C$_3$ have also shown that these materials can also be intercalated with Li and used in lithium ion batteries.

Example 13: Sheet Resistivities and Contact Angles of Mxene Discs.

To measure the sheet resistances and the contact angle, MXene discs (25 mm in diameter, 300 μm thick) were cold-pressed from the reacted powders. The latter were placed in a die and cold-pressed to a load corresponding to a stress of 1 GPa. The surface or sheet resistances of cold-pressed, free-standing MXene discs were measured using a four-probe technique (Cascade Probe Station CPS-1303-24 with 4-point probe head Alessi C4S-57, Cascade Microtech, Inc., Beaverton, USA).

Contact angle measurements of deionized water were also performed at room temperature using the sessile drop technique. Ten microliter water drops were placed on the surfaces of cold-pressed MXene discs. The contact angles were measured from photographs taken with a CCD camera yielding an accuracy of approximately ±3°.

The densities of the cold-pressed discs of the various MXene compositions (Table 2) varied between 2.91 g/cm3 for Ti2C to 6.82 g/cm3 for Ta4C3. If one assumes the c lattice parameters listed in Table 1 and OH terminated surfaces of MXene sheets, then it is possible to calculate the theoretical densities. The last row in Table 2 lists the measured densities of the pressed discs. The numbers in parentheses list the % of theoretical densities that range from 50 to ≈65%.

The sheet resistivity and resistivities of the various MXene discs are also shown in Table 2. The resistivity values are higher than the MAX phases before treatment ($<10\,\Omega/\square$) presumably because of the replacement of the A layers with OH and/or F. When it is assumed that surface groups are similar in all of the exfoliated MAX phases, the difference in the resistivity between the different phases can be partially explained by the different number of atomic layers (3, 5, and 7 for $M_2X$, $M_3X_2$, and $M_4X_3$ phases, respectively). It is important to note that the resistivity values reported in **TABLE 2** should be significantly higher than single MXene sheets because of the method by which the resistivity was measured. For example, the resistivity of bulk sintered $Ti_3AlC_2$ is 0.39 $\mu\Omega$m.25 When $Ti_3AlC_2$ powders were cold-pressed at 1 GP, their resistivity increased to 1200 $\mu\Omega$-m, a, roughly, 3000 time increase.

Contact angle measurement results for water droplets on the cold-pressed discs of exfoliated phases are also listed in **TABLE 2.** These values are lower than those of the corresponding MAX phases -- that were also measured in this work on cold-pressed samples, which were around 60°. The reduction in contact angle can be explained by the presence of OH surface groups after the HF treatment. In contradistinction, graphene can be transformed from superhydrophopic to superhydrophilic by altering the surface groups. The hydrophilicity of the MXenes would be an advantage when using aqueous electrolytes in energy storage devices or dispersing in water and alcohols for further processing.

| TABLE 2. resistivity and Contact Angle of Water on Cold-Pressed Free-Standing Discs for Different Exfoliated Phases and Their Densities | | | | | |
|---|---|---|---|---|---|
| Property | $Ti_2C$ | TiNbC | $Ti_3CNx$ | Ta4C3 | $Ti_3C_2$ |
| Resistivity, $\Omega/\square$ | 339 | 171 | 125 | 104 | 22 |
| Resistivity, $\Omega$ m | 0.068 | 0.052 | 0.037 | 0.021 | 0.005 |
| Contact angle, deg | 32 | 31 | 27 | 41 | 34 |
| Density of cold pressed discs[a], g/cm³ (% of theoretical) | 2.91 (62%) | 3.23 (52%) | 2.95 (64%) | 6.82 (53%) | 3.12 (60%) |
| [a] The densities were estimated from the dimensions and weights of the cold-pressed discs. Number in parentheses is relative theoretical density assuming OH termination of the MX-ene surfaces and the c parameters listed in Table 1. | | | | | |

As those skilled in the art will appreciate, numerous modifications and variations of the present invention are possible in light of these teachings, and all such are contemplated hereby.

## Claims

1. A composition comprising at least one free-standing layer having first and second surfaces, each layer comprising:

   a two-dimensional array of crystal cells having a thickness of a single crystal cell, wherein the top and bottom surfaces of the array are available for chemical modification,
   each crystal cell having an empirical formula of $M_{n+1}\,X_n$,
   such that each X is positioned within an octahedral array of M,
   wherein M is at least one Group IIIB, IVB, VB, or VIB metal,
   wherein each X is C and/or N,
   and n = 1, 2, or 3;
   wherein at least one of the surfaces of each layer has bound thereto alkoxide, carboxylate, halide, hydroxide, hydride, oxide, sub-oxide, nitride, subnitride, sulfide, thiol, or a combination thereof.

2. The composition of claim 1 comprising a plurality of layers, wherein both surfaces of each layer have bound thereto alkoxide, carboxylate, halide, hydroxide, hydride, oxide, sub-oxide, nitride, subnitride, sulfide, thiol, or a combination thereof.

3. The composition of claim 1 or 2, wherein M is at least one Group IVB, Group VB, or Group VIB metal.

4. The composition of claim 2 or 3 wherein M is Ti and n is 1 or 2.

5. The composition of claim 2 or 3 wherein M is Ta and n is 2 or 3.

6. The composition of any one of the preceding claims, wherein $M_{n+1}X_n$, comprises $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3N_2$, $Ta_3C_2$, $Ta_3N_2$, $Ti_4C_3$, $Ti_4N_3$, $V_4C_3$, $V_4N_3$, $Ta_4C_3$, or $Ta_4N_3$.

7. The composition of claim 1 wherein $M_{n+1}X_n$ is $Ti_3C_2$, $Ti_3CN$, $Ti_2C$, $Ta_4C_3$, or (V1/2Cr1/2)3C2.

8. The composition of any preceding claim wherein the surface of each layer has bound thereto fluoride ions.

9. The composition of any preceding claim wherein the surface of each layer has bound thereto hydrated or anhydrous oxide or sub-oxide, or combination thereof.

10. The composition of any one of claims 1-9, wherein the composition is electrically conductive or semiconductive.

11. A stacked assembly of at least two free-standing layers having first and second surfaces, each free-standing layer comprising:

a two-dimensional array of crystal cells having a thickness of a single crystal cell, wherein the top and bottom surfaces of the array are available for chemical modification,
each crystal cell having the empirical formula of $M_{n+1}X_n$, such that each X is positioned within an octahedral array of M;
wherein M is at least one Group IIIB, IVB, VB, or VIB metal;
each X is C or N; and
n = 1, 2, or 3;
wherein the layers are characterized as having an average surface area and interlayer distance;
wherein at least one of the surfaces of each layer has bound thereto alkoxide, carboxylate, halide, hydroxide, hydride, oxide, sub-oxide, nitride, subnitride, sulfide, thiol, or a combination thereof.

12. The stacked assembly of claim 11 wherein $M_{n+1}X_n$, comprises $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3C_2$, $Ta_3C_2$, $Ta_3N_2$, $Ti_4C_3$, $Ti_4N_3$, $V_4C_3$, $V_4N_3$, $Ta_4C_3$, or $Ta_4N_3$.

13. The stacked assembly of claim 11, wherein $M_{n+1}X_n$ is $Ti_3C_2$, $Ti_3CN$, $Ti_2C$, $Ta_4C_3$, or $(V_{1/2}Cr_{1/2})_3C_2$.

14. The stacked assembly of claim 11, wherein Mn+1Xn comprises $Ti_2C$, $Ti_2N$, $Ti_3C_2$, $Ti_3N_2$, $Ti_4C_3$, $Ti_4N_3$, $Ta_4C_3$, or $Ta_4N_3$, or a combination thereof.

15. The stacked assembly of any one of claims 11-14 wherein the number of layers is in the range of 2 to about 50.

16. The stacked assembly of any one of claims 11-15 wherein the average area of the layers is in the range of about 100 $nm^2$ to about 10,000 $nm^2$ or about 100 $\mu m^2$ to about 10,000 $\mu m^2$.

17. The stacked assembly of any one of claims 11-16 capable of intercalating atoms and/or ions between at least some of the layers.

18. The stacked assembly of any one of claims 11-16 wherein lithium atoms, lithium ions, or both lithium atoms and lithium ions are intercalated between at least some of the layers.

19. An energy-storing device comprising the stacked assembly of claim 18.

20. A method of preparing a composition according to any one of claims 1 to 10, the method comprising:

removing the A atoms from a MAX-phase composition having an empirical formula of $M_{n+1}AX_n$,
wherein M is at least one Group IIIB, IVB, VB, or VIB metal,
wherein A is an A-group element, said A-group element consisting of Al, As, Cd, Ga, Ge, P, Pb, In, S, Sn, Si, or Tl
each X is C or N; and
n = 1, 2, or 3.

21. The method of claim 20 wherein the A atoms are removed by a process comprising a treatment with an acid.

**22.** The method of claim 21 wherein the acid is a strong, fluorine-containing acid.

**23.** The method of claim 22 wherein the fluorine-containing acid is aqueous hydrofluoric acid.

**24.** The composition of any one of claims 1 to 10, wherein M is at least one of Sc, Y, Lu, Ti, Zr, Hf, V, Nb, Ta, Cr, Mo, or W.

**25.** The composition of claim 1, wherein the composition is formed by removing the A atoms from a MAX-phase composition having an empirical formula of $M_{n+1}AX_n$, wherein A is an A-group element, said A-group element consisting of Al, As, Cd, Ga, Ge, P, Pb, In, S, Sn, or Tl, or the method of claim 20, wherein said A-group element consists of Al, As, Cd, Ga, Ge, P, Pb, In, S, Sn, or Tl.

**26.** The composition of claim 1, wherein at least one of the surfaces of each layer has bound thereto alkoxide, carboxylate, hydroxide, hydride, oxide, sub-oxide, nitride, subnitride, sulfide, thiol, or a combination thereof.

**Patentansprüche**

**1.** Zusammensetzung umfassend wenigstens eine freistehende Schicht mit ersten und zweiten Oberflächen, wobei jede Schicht umfasst:

ein zweidimensionales Array von Kristallzellen mit einer Dicke einer einzelnen Kristallzelle, wobei die oberen und unteren Oberflächen des Arrays für chemische Modifikation verfügbar sind,
wobei jede Kristallzelle eine empirische Formel von $M_{n+1}X_n$ aufweist,
so dass jedes X innerhalb eines oktaedrischen Arrays von M angeordnet ist,
wobei M wenigstens ein Gruppe-IIIB-, -IVB-, -VB- oder -VIB-Metall ist,
wobei jedes X C und/oder N ist,
und n = 1, 2 oder 3;
wobei wenigstens eine der Oberflächen jeder Schicht Alkoxid, Carboxylat, Halogenid, Hydroxid, Hydrid, Oxid, Suboxid, Nitrid, Subnitrid, Sulfid, Thiol oder eine Kombination davon daran gebunden aufweist.

**2.** Zusammensetzung gemäß Anspruch 1, umfassend eine Vielzahl von Schichten, wobei beide Oberflächen jeder Schicht Alkoxid, Carboxylat, Halogenid, Hydroxid, Hydrid, Oxid, Suboxid, Nitrid, Subnitrid, Sulfid, Thiol oder eine Kombination davon daran gebunden aufweisen.

**3.** Zusammensetzung gemäß Anspruch 1 oder 2, wobei M wenigstens ein Gruppe-IVB-, Gruppe-VB- oder Gruppe-VIB-Metall ist.

**4.** Zusammensetzung gemäß Anspruch 2 oder 3, wobei M Ti ist und n 1 oder 2 ist.

**5.** Zusammensetzung gemäß Anspruch 2 oder 3, wobei M Ta ist und n 2 oder 3 ist.

**6.** Zusammensetzung gemäß einem der vorstehenden Ansprüche, wobei $M_{n+1}X_n$ $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3N_2$, $Ta_3C_2$, $Ta_3N_2$, $Ti_4C_3$, $Ti_4N_3$, $V_4C_3$, $V_4N_3$, $Ta_4C_3$ oder $Ta_4N_3$ umfasst.

**7.** Zusammensetzung gemäß Anspruch 1, wobei $M_{n+1}X_n$ $Ti_3C_2$, $Ti_3CN$, $Ti_2C$, $Ta_4C_3$ oder (V1/2Cr1/2)3C2 ist.

**8.** Zusammensetzung gemäß einem der vorstehenden Ansprüche, wobei die Oberfläche jeder Schicht Fluoridionen daran gebunden aufweist.

**9.** Zusammensetzung gemäß einem der vorstehenden Ansprüche, wobei die Oberfläche jeder Schicht hydratisiertes oder wasserfreies Oxid oder Suboxid oder eine Kombination davon daran gebunden aufweist.

**10.** Zusammensetzung gemäß einem der Ansprüche 1-9, wobei die Zusammensetzung elektrisch leitfähig oder halbleitend ist.

**11.** Gestapelte Anordnung von wenigstens zwei freistehenden Schichten mit ersten und zweiten Oberflächen, wobei jede freistehende Schicht umfasst:

ein zweidimensionales Array von Kristallzellen mit einer Dicke einer einzelnen Kristallzelle, wobei die oberen und unteren Oberflächen des Arrays für chemische Modifikation verfügbar sind,

wobei jede Kristallzelle die empirische Formel $M_{n+1}X_n$ aufweist, so dass jedes X innerhalb eines oktaedrischen Arrays von M angeordnet ist,

wobei M wenigstens ein Gruppe-IIIB-, -IVB-, -VB- oder -VIB-Metall ist,

wobei jedes X C oder N ist, und

n = 1, 2 oder 3;

wobei die Schichten **dadurch gekennzeichnet sind, dass** sie eine mittlere Oberfläche und einen Zwischenschichtabstand aufweisen;

wobei wenigstens eine der Oberflächen jeder Schicht Alkoxid, Carboxylat, Halogenid, Hydroxid, Hydrid, Oxid, Suboxid, Nitrid, Subnitrid, Sulfid, Thiol oder eine Kombination davon daran gebunden aufweist.

12. Gestapelte Anordnung gemäß Anspruch 11, wobei $M_{n+1}X_n$ $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3N_2$, $Ta_3C_2$, $Ta_3N_2$, $Ti_4C_3$, $Ti_4N_3$, $V_4C_3$, $V_4N_3$, $Ta_4C_3$ oder $Ta_4N_3$ umfasst.

13. Gestapelte Anordnung gemäß Anspruch 11, wobei $M_{n+1}X_n$ $Ti_3C_2$, $Ti_3CN$, $Ti_2C$, $Ta_4C_3$ oder (V1/2Cr1/2)3C2 ist.

14. Gestapelte Anordnung gemäß Anspruch 11, wobei Mn+1Xn $Ti_2C$, $Ti_2N$, $Ti_3C_2$, $Ti_3N_2$, $Ti_4C_3$, $Ti_4N_3$, $Ta_4C_3$ oder $Ta_4N_3$ oder eine Kombination davon umfasst.

15. Gestapelte Anordnung gemäß einem der Ansprüche 11-14, wobei die Anzahl von Schichten in dem Bereich von 2 bis etwa 50 liegt.

16. Gestapelte Anordnung gemäß einem der Ansprüche 11-15, wobei die mittlere Fläche der Schichten in dem Bereich von etwa 100 $nm^2$ bis etwa 10.000 $nm^2$ oder etwa 100 $\mu m^2$ bis etwa 10.000 $\mu m^2$ liegt.

17. Gestapelte Anordnung gemäß einem der Ansprüche 11-16, fähig zum Interkalieren von Atomen und/oder Ionen zwischen wenigstens manche der Schichten.

18. Gestapelte Anordnung gemäß einem der Ansprüche 11-16, wobei Lithiumatome, Lithiumionen oder sowohl Lithiumatome als auch Lithiumionen zwischen wenigstens manche der Schichten interkaliert sind.

19. Energiespeichervorrichtung umfassend die gestapelte Anordnung gemäß Anspruch 18.

20. Verfahren zur Herstellung einer Zusammensetzung gemäß einem der Ansprüche 1 bis 10, wobei das Verfahren umfasst:

Entfernen der A-Atome aus einer MAX-Phase-Zusammensetzung mit einer empirischen Formel von $M_{n+1}AX_n$, wobei M wenigstens ein Gruppe-IIIB-, -IVB-, -VB- oder -VIB-Metall ist,

wobei A ein A-Gruppe-Element ist, wobei das A-Gruppe-Element aus Al, As, Cd, Ga, Ge, P, Pb, In, S, Sn, Si oder TI besteht,

jedes X C oder N ist; und

n = 1, 2 oder 3.

21. Verfahren gemäß Anspruch 20, wobei die A-Atome durch ein Verfahren umfassend eine Behandlung mit einer Säure entfernt werden.

22. Verfahren gemäß Anspruch 21, wobei die Säure eine starke, fluorhaltige Säure ist.

23. Verfahren gemäß Anspruch 22, wobei die fluorhaltige Säure wässrige Fluorwasserstoffsäure ist.

24. Verfahren gemäß einem der Ansprüche 1 bis 10, wobei M wenigstens eines von Sc, Y, Lu, Ti, Zr, Hf, V, Nb, Ta, Cr, Mo oder W ist.

25. Zusammensetzung gemäß Anspruch 1, wobei die Zusammensetzung durch Entfernen der der A-Atome aus einer MAX-Phase-Zusammensetzung mit einer empirischen Formel von $M_{n+1}AX_n$ gebildet ist, wobei A ein A-Gruppe-Element ist, wobei das A-Gruppe-Element aus Al, As, Cd, Ga, Ge, P, Pb, In, S, Sn, Si oder TI besteht,

oder das Verfahren gemäß Anspruch 20, wobei das A-Gruppe-Element aus Al, As, Cd, Ga, Ge, P, Pb, In, S, Sn, Si oder TI besteht.

26. Zusammensetzung gemäß Anspruch 1, wobei wenigstens eine der Oberflächen jeder Schicht Alkoxid, Carboxylat, Hydroxid, Hydrid, Oxid, Suboxid, Nitrid, Subnitrid, Sulfid, Thiol oder eine Kombination davon daran gebunden aufweist.

**Revendications**

1. Composition comprenant au moins une couche autoportante ayant des première et deuxième surfaces, chaque couche comprenant :

   un réseau bidimensionnel de cellules cristallines ayant une épaisseur d'une cellule cristalline unique, les surfaces supérieures et inférieures du réseau étant disponibles pour une modification chimique,
   chaque cellule cristalline ayant une formule empirique de $M_{n+1}X_n$,
   de sorte que chaque X est positionné à l'intérieur d'un réseau octaédrique de M,
   M étant au moins un métal du groupe IIIB, IVB, VB ou VIB, chaque X étant C et/ou N,
   et n = 1, 2 ou 3 ;
   au moins l'une des surfaces de chaque couche ayant, lié à celle-ci, un alcoxyde, un carboxylate, un halogénure, un hydroxyde, un hydrure, un oxyde, un sous-oxyde, un nitrure, un sous-nitrure, un sulfure, un thiol ou une combinaison correspondante.

2. Composition selon la revendication 1 comprenant une pluralité de couches, les deux surfaces de chaque couche ayant, lié à celle-ci, un alcoxyde, un carboxylate, un halogénure, un hydroxyde, un hydrure, un oxyde, un sous-oxyde, un nitrure, un sous-nitrure, un sulfure, un thiol ou une combinaison correspondante.

3. Composition selon la revendication 1 ou 2, M étant au moins un métal du groupe IVB, du groupe VB ou du groupe VIB.

4. Composition selon la revendication 2 ou 3, M étant Ti et n étant 1 ou 2.

5. Composition selon la revendication 2 ou 3, M étant Ta et n étant 2 ou 3.

6. Composition selon l'une quelconque des revendications précédentes, $M_{n+1}X_n$ comprenant $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3N_2$, $Ta_3C_2$, $Ta_3N_2$, $Ti_4C_3$, $Ti_4N_3$, $V_4C_3$, $V_4N_3$, $Ta_4C_3$, ou $Ta_4N_3$.

7. Composition selon la revendication 1, $M_{n+1}X_n$ étant $Ti_3C_2$, $Ti_3CN$, $Ti_2C$, $Ta_4C_3$, ou (V1/2Cr1/2)3C2.

8. Composition selon une quelconque revendication précédente, la surface de chaque couche ayant, liés à celle-ci, des ions fluorure.

9. Composition selon une quelconque revendication précédente, la surface de chaque couche ayant, lié à celle-ci, un oxyde ou sous-oxyde hydraté ou anhydre, ou une combinaison correspondante.

10. Composition selon l'une quelconque des revendications 1-9, la composition étant électriquement conductrice ou semi-conductrice.

11. Ensemble empilé d'au moins deux couches auto-portantes ayant des première et deuxième surfaces, chaque couche auto-portante comprenant :

   un réseau bidimensionnel de cellules cristallines ayant une épaisseur d'une cellule cristalline unique, les surfaces supérieures et inférieures du réseau étant disponibles pour une modification chimique,
   chaque cellule cristalline ayant la formule empirique de $M_{n+1}X_n$, de sorte que chaque X est positionné à l'intérieur d'un réseau octaédrique de M ;
   M étant au moins un métal du groupe IIIB, IVB, VB ou VIB, chaque X étant C ou N ; et
   n = 1, 2 ou 3 ;
   les couches étant **caractérisées par le fait qu'**elles possèdent une superficie et une distance inter-couche moyennes ;
au moins l'une des surfaces de chaque couche ayant, lié à celle-ci, un alcoxyde, un carboxylate, un halogénure, un hydroxyde, un hydrure, un oxyde, un sous-oxyde, un nitrure, un sous-nitrure, un sulfure, un thiol ou une combinaison correspondante.

12. Ensemble empilé selon la revendication 11, $M_{n+1}X_n$ comprenant $Sc_2C$, $Sc_2N$, $Ti_2C$, $Ti_2N$, $V_2C$, $V_2N$, $Cr_2C$, $Cr_2N$, $Zr_2C$, $Zr_2N$, $Nb_2C$, $Nb_2N$, $Hf_2C$, $Hf_2N$, $Ti_3C_2$, $Ti_3N_2$, $V_3C_2$, $V_3C_2$, $Ta_3C_2$, $Ta_3N_2$, $Ti_4C_3$, $Ti_4N_3$, $V_4C_3$, $V_4N_3$, $Ta_4C_3$ ,ou $Ta_4N_3$.

13. Ensemble empilé selon la revendication 11, $M_{n+1}X_n$ étant $Ti_3C_2$, $Ti_3CN$, $Ti_2C$, $Ta_4C_3$, ou $(V_{1/2}Cr_{1/2})_3C_2$.

14. Ensemble empilé selon la revendication 11, Mn+1Xn comprenant $Ti_2C$, $Ti_2N$, $Ti_3C_2$, $Ti_3N_2$, $Ti_4C_3$, $Ti_4N_3$, $Ta_4C_3$, ou $Ta_4N_3$, ou une combinaison correspondante.

15. Ensemble empilé selon l'une quelconque des revendications 11 à 14, le nombre de couches étant dans la plage de 2 à environ 50.

16. Ensemble empilé selon l'une quelconque des revendications 11 à 15, la superficie moyenne des couches étant dans la plage d'environ 100 nm$^2$ à environ 10 000 nm$^2$ ou d'environ 100 $\mu$m$^2$ à environ 10 000 $\mu$m$^2$.

17. Ensemble empilé selon l'une quelconque des revendications 11 à 16 capable d'intercaler des atomes et/ou des ions entre au moins certaines des couches.

18. Ensemble empilé selon l'une quelconque des revendications 11 à 16, des atomes de lithium, des ions lithium ou à la fois des atomes de lithium et des ions lithium étant intercalés entre au moins certaines des couches.

19. Dispositif de stockage d'énergie comprenant l'ensemble empilé selon la revendication 18.

20. Procédé de préparation d'une composition selon l'une quelconque des revendications 1 à 10, le procédé comprenant :

l'élimination des atomes de A d'une composition de phase MAX ayant une formule empirique de

$$M_{n+1}AX_n,$$

M étant au moins un métal du groupe IIIB, IVB, VB ou VIB, A étant un élément du groupe A, ledit élément du groupe A étant constitué de Al, As, Cd, Ga, Ge, P, Pb, In, S, Sn, Si, ou Tl
chaque X étant C ou N ; et
et n = 1, 2 ou 3.

21. Procédé selon la revendication 20, les atomes de A étant éliminés par un processus comprenant un traitement par un acide.

22. Procédé selon la revendication 21, l'acide étant un acide fort, contenant du fluor.

23. Procédé selon la revendication 22, l'acide contenant du fluor étant l'acide fluorhydrique aqueux.

24. Composition selon l'une quelconque des revendications 1 à 10, M étant au moins l'un parmi Sc, Y, Lu, Ti, Zr, Hf, V, Nb, Ta, Cr, Mo, ou W.

25. Composition selon la revendication 1, la composition étant formée par élimination des atomes de A d'une composition de phase MAX ayant une formule empirique de $M_{n+1}AX_n$, A étant un élément du groupe A, ledit élément du groupe A étant constitué de Al, As, Cd, Ga, Ge, P, Pb, In, S, Sn, Si, ou Tl, ou procédé selon la revendication 20, ledit élément du groupe A étant constitué de Al, As, Cd, Ga, Ge, P, Pb, In, S, Sn, Si, ou Tl.

26. Composition selon la revendication 1, au moins l'une des surfaces de chaque couche ayant, lié à celle-ci, un alcoxyde, un carboxylate, un hydroxyde, un hydrure, un oxyde, un sous-oxyde, un nitrure, un sous-nitrure, un sulfure, un thiol ou une combinaison correspondante.

**FIG. 1**

(A) $M_2X$ — A — 211

(B) $M_3X_2$ — A — 312

(C) $M_4X_3$ — A — 413

# FIG. 2

EP 2 723 559 B1

FIG. 3

**FIG. 4**

FIG. 5

EP 2 723 559 B1

**FIG. 6**

FIG. 7

FIG. 8

# Ti$_2$AlC HF 10% 10 hrs at RT

EP 2 723 559 B1

FIG. 9

EP 2 723 559 B1

FIG. 10

FIG. 11

$Ti_3AlCN$ HF 30% 18 hrs at RT

34

FIG. 12

Ti$_3$AlCN HF 30% 18 hrs at RT

FIG. 13

Ti₃AlCN HF 30% 18 hrs at RT

**FIG. 14**

$(V_{0.5}Cr_{0.5})_3AlC_2$ HF 50% 69 hrs at RT

FIG. 15

(V0.5Cr0.5)3AlC2 HF 50% 69 hrs at RT

FIG. 16

# (V0.5Cr0.5)3AlC2 HF 50% 69 hrs at RT

EP 2 723 559 B1

FIG. 17

# Ti$_3$C$_2$ exfoliated at 65 °C during 2h

| Element | Weight % | Atomic % |
|---------|----------|----------|
| C K | 6.85 | 15.81 |
| O K | 8.87 | 15.38 |
| F K | 21.52 | 31.40 |
| Al K | 2.42 | 2.49 |
| Ti K | 60.34 | 34.93 |
| Totals | 100 | |

Drexel MCF  EHT = 15.00 kV  1 µm  WD = 12 mm  Vacuum Mode = High Vacuum  File Name = Ti3C2 exfoliated 65C03.tif
Zeiss Supra 50VP  Mag = 4.00 K X  Detector = SE2  Date :31 May 2011  Time :15:43:00  MA

FIG. 18(a)

TEM graph of Ti$_3$C$_2$ (exfoliation of Ti$_3$AlC$_2$ with 50% solution of HF during 22h)

FIG. 18(b)

Edges of layered structure

20 nm

**FIG. 19**

# Dependence on temperature of HF treatment

| Temperature of exfoliation, °C | Intensity ratio $Ti_3AlC_2 / Ti_3C_2$ | $Ti_3C_2$, wt.% |
|---|---|---|
| 20 | 2.00 | 57 |
| 30 | 1.22 | 67 |
| 35 | 1.69 | 60 |
| 40 | 0.53 | 79 |
| 50 | 0 | 100 |
| 65 | 0 | 100 |

EP 2 723 559 B1

**FIG. 20**

Dependence on time of HF treatment

**FIG. 21**

# Resistivity

| Parameters | Ti$_2$AlC$_2$ + 50% HF, at ambient temperature | | | | |
|---|---|---|---|---|---|
| | 2h | 6h | 10h | 15h | 19h |
| | 8.2 | 7.3 | 8.5 | 12.0 | 13.0 |
| | 7.2 | 7.5 | 8.9 | 11.7 | 14.9 |
| | 7.2 | 8.8 | 8.1 | 11.9 | 14.5 |
| Resistance, Ω | 6.1 | 8.7 | 7.3 | 13.7 | 12.5 |
| | 7.0 | 8.6 | 7.8 | 12.9 | 12.2 |
| | 7.1 | 9.4 | 7.5 | 13.5 | 17.4 |
| Resistance (average), Ω | 7.1 | 8.4 | 8.0 | 12.6 | 14.1 |
| Resistivity, Ω/□ | 32.3 | 38.0 | 36.3 | 57.2 | 63.8 |

*Assumption*: we have infinite sheet

EP 2 723 559 B1

**FIG. 22**

Dependence on $Ti_3AlC_2$ particle size

| Particle size, μm | Intensity ratio $Ti_3AlC_2$ / $Ti_3C_2$ | $Ti_3AlC_2$, wt.% | $Ti_3C_2$ wt.% |
|---|---|---|---|
| < 38 | 0 | 0 | 100 |
| 38 – 53 | 0 | 0 | 100 |
| Nonmilled | 2.00 | 43 | 57 |

FIG. 23

# Calibration curve for HF treatment of $Ti_3AlC_2$

**FIG. 24**

# TGA graphs for two samples dried at different conditions

Sample #1, Ti$_3$C$_2$(O$_x$F$_y$H$_z$) 100 °C, vacuum oven

Sample #2 Ti$_3$C$_2$(O$_x$F$_y$H$_z$) dried in air at room temp

<u>Mass loss:</u>
Sample #1: 1.79 mg
     (4.76 %)
Sample #2: 3.44 mg
     (8.57 %)

<u>Ramp:</u>
50.00 °C/min to 30 °C
5.00 °C/min to 500 °C

<u>Sample gas:</u>
N$_2$ @ 60.0 ml/min

**FIG. 25**

Results&Discussion
SWPP + SWCP

12M HCl; Ar; 30°C; 0.05 V s⁻¹

2.4V
-1V
SWPP

After 4600s I expected ~50 mA (@ 2.4V)

$\Delta m_{tot}$ −56.2 wt.% (per Sn)

SWCP
143 mA g⁻¹
−9.5 mA g⁻¹

SWCP
143 mA g⁻¹
−9.5 mA g⁻¹

**FIG. 26**

RAMAN spectroscopy
Ti2snC Electrochem. Treated

Intensity

Raman Shift, cm$^{-1}$

EP 2 723 559 B1

**FIG. 27**

XRD

**FIG. 28(A)**

**FIG. 28(B)**

EP 2 723 559 B1

# FIG. 28(C)

Figure 3. (a) SEM image of the exfoliated material obtained after the electrochemical anodic polarization treatment of the Ti2SnC MAX phase in 12M HCl. Red circle represents approximate area subjected to the EDS analysis. (b) Composition distribution diagram, calculated by normalizing atomic percentage of individual components by the atomic percentage of Sn as obtained from EDS.

EP 2 723 559 B1

FIG. 29(A)

# MXene : with binder and CB Capacity compared to Ti₃AlC₂ with binder and CB

EP 2 723 559 B1

**FIG. 29(B)**

# MXene : with binder and CB Capacity compared to Ti$_3$AlC$_2$ with binder and CB and compared to exfoliated without CB

- Difference between Exfoliated with and without CB:
  - 50 mAh/gm in 1$^{st}$ discharging cycle
  - 100 mAh/gm in the 2$^{nd}$ discharging cycle
- Can not be CB capacity, should be conductivity problem

EP 2 723 559 B1

**FIG. 30**

Upper curve of (b) refers to absorption;
lower curve refers to desorption.

EP 2 723 559 B1

**FIG. 31(A)**

**FIG. 31(B)**

EP 2 723 559 B1

**FIG. 31(C)**

EP 2 723 559 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007093011 A1

**Non-patent literature cited in the description**

- **BARSOUM** ; **FARBER**. *Science*, 1999, vol. 284, 937-939
- **TRAVAGLINI et al.** *Corrosion Science*, 2003, vol. 45, 1313-1327
- **BARSOUM et al.** *Journal of The Electrochemical Society*, 1999, vol. 146, 3919-3923
- **BARSOUM et al.** *Progress in Solid State Chemistry*, 2000, vol. 28, 201-281
- **P. H. NADEAU**. *Applied Clay Science*, 1987, vol. 2, 83
- **S. STANKOVICH et al.** *Nature*, 2006, vol. 442, 282
- **M.W. BARSOUM et al.** Synthesis and Characterization of a Remarkable Ceramic: Ti3SiC. *J. Amer. Ceramics. Soc.*, 1996, vol. 79, 1953-1956
- **M. W. BARSOUM**. The MN+1AXN Phases: A New Class of Solids: Thermodynamically Stable Nanolaminates. *Progress in Solid State Chemistry*, 2000, vol. 28, 201-281
- **C. N. R. RAO et al.** *Science and Technology of Advanced Materials*, 2010, vol. 0545 02
- **J. SPANIER** ; **S. GUPTA** ; **M. AMER** ; **M. W. BARSOUM**. *Physical Review B*, 2005, vol. 71, 012103
- **S. MYHRA et al.** *Journal of Physics and Chemistry of Solids*, 2001, vol. 62, 811
- **M. SCHMIDT** ; **S. G. STEINEMANN**. *Fresenius' Journal of Analytical Chemistry*, 1991, vol. 341, 41-2
- **L. M. VICULIS et al.** *Journal of Materials Chemistry*, 2005, vol. 15, 974
- **L. M. VICULIS et al.** *Science*, 2003, vol. 299, 1361
- **M. V. SAVOSKIN et al.** *Carbon*, 2007, vol. 45, 2797